# EUROPEAN PATENT SPECIFICATION

(11) **EP 3 795 252 B1**
(45) Date of publication and mention of the grant of the patent: **24.12.2025**
(21) Application number: 19198483.0
(22) Date of filing: 19.09.2019
(51) Int. Cl.: B01L 3/00

(54) **CONDUCTIVE SPACER FOR A MICROFLUIDIC DEVICE**
LEITFÄHIGER ABSTANDSHALTER FÜR EINE MIKROFLUIDISCHE VORRICHTUNG
ESPACEUR CONDUCTEUR POUR UN DISPOSITIF MICROFLUIDIQUE

(43) Date of publication of application: 24.03.2021
(73) Proprietor: Sharp Life Science (EU) Limited, Oxford, Oxfordshire OX4 4GB (GB)
(72) Inventor: PARRY-JONES, Lesley Anne, Oxford, Oxfordshire OX4 4GB (GB); WALTON, EMMA JAYNE, Oxford, Oxfordshire OX4 4GB (GB); BROWN, Christopher James, Oxford, Oxfordshire OX4 4GB (GB)
(74) Representative: EIP

(56) References cited:
- EP-A1- 3 427 832
- JP-A- 2013 142 753
- US-A1- 2013 314 625
- US-A1- 2013 335 285
- US-A1- 2016 202 587

## Description

### TECHNICAL FIELD

The present invention relates to a microfluidic device and a method of using such a device. Aspects of the invention relate to pre-charging a droplet of fluid either as it is transferred into the microfluidic device or at some point after it is transferred into the microfluidic device. Further aspects of the invention relate to conductive circuits for interrogating the property of one or more droplets within the microfluidic device.

### BACKGROUND ART

European patent applications of the applicant, Nos. 18182737.9. 18182772.6, 18194096.6, and 18194098.2, published as EP 3427831 A1, EP 3427832 A1, EP 3623049 A1 and EP 3623050 A1 respectively, disclose aspects of a microfluidic system including a side-fill configuration and a moulded housing for a microfluidic element.

US 9,019,200 discloses a method for driving an electro-wetting display panel and electro-wetting display apparatus for performing the same.

Choi, K., Im, M., Choi, JM. et al. Microfluid Nanofluid (2012) 12: 821 (https://link.springer.com/article/10.1007/s10404-011-0921-3) describe "Droplet transportation using a pre-charging method for digital microfluidics". The authors describe that a droplet is initially charged by applying "pre-charging" voltage between the droplet and an electrode buried under dielectric layers. The droplet is then driven to the next electrode by applying "driving" voltage between two adjacent buried electrodes. The concept of pre-charging was proved by the polarity of the charge stored in the droplet. When the droplet is pre-charged with positive voltage, it is driven with negative voltage and vice versa. Choi *et al.* also disclose "In this paper, we propose a new droplet-driving scheme for a single-plate structured digital microfluidic device through the use of the "pre-charging of a droplet" method." Choi *et al.* do not disclose an enclosed microfluidic device where there is a gasket (which may be a conductive gasket) that defines a gap distance between plate elements having conductive circuits thereon.

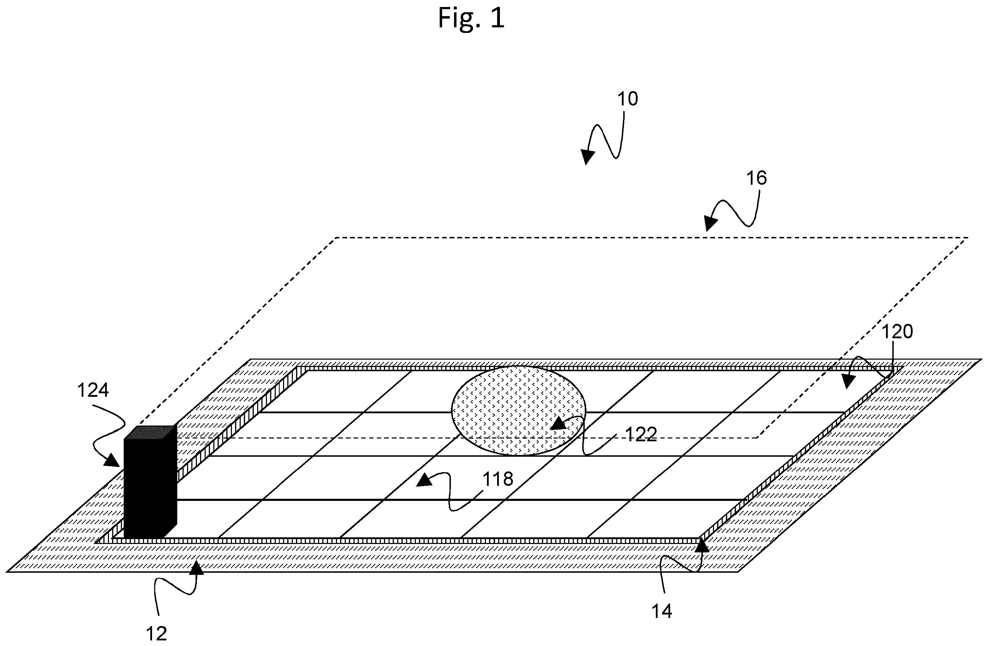

Fig. 1 is a perspective view depicting details of an exemplary active matrix electrowetting on dielectric (AM-EWOD) device 10 in schematic perspective. The AM-EWOD device 10 has a lower substrate 12 with thin film electronics 14 disposed upon the lower substrate 12; a reference electrode (not shown) is incorporated into an upper substrate 16. Lower substrate 12 and upper substrate 16 define a channel or gap (also referred to as a "fluid chamber") therebetween. The electrode configuration may be reversed, with the thin film electronics being incorporated into the upper substrate and the reference electrode being incorporated into the lower substrate. The thin film electronics 14 are arranged to drive array element electrodes 18. A plurality of array element electrodes 118 are arranged in an electrode or element array 120, having X by Y array elements where X and Y may be any integer. The term "plate element" may be used to denote the combination of a substrate and the various components, such as any electrode(s) and/or any thin film electronics, disposed on that substrate.

A liquid droplet 122 which may include any polar liquid and which typically may be aqueous, is enclosed between the lower substrate 14 and the upper substrate 16 separated by a spacer 124, although it will be appreciated that multiple liquid droplets 122 may be present. Liquid droplet 122 may typically exist within a layer of non-polar liquid, which may be an oil (not shown) that generally fills the channel between lower substrate 12 and upper substrate 16.

Liquid droplets 122 including a polar material, i.e., the droplets to be manipulated by operation of the AM-EWOD device, must be inputted from an external "reservoir" of fluid into the AM-EWOD channel. The external reservoir may for example be a pipette, or may be a structure incorporated into the housing of the device. As fluid from the reservoir enters the AM-EWOD, oil is generally displaced and may be removed from the AM-EWOD channel.

Liquid droplets (122) may be manipulated in an automated fashion in order to perform some kind of protocol or test. In the case of a test, it may be possible to perform the test on the droplets whilst they remain inside the device. The droplets may be interrogated in a number of ways, including electrically and optically. In the case of an electrical interrogation there may be a need for a more complex device configuration than if no electrical interrogation was to be carried out.

Microfluidic devices such as Electrowetting-on-Dielectric (EWOD) devices function most effectively when the droplets are in perfect or close electrical contact with a reference electrode. In many devices, the reference electrode is supplied by a simple conducting substrate that opposes the other (more complex) substrate that contains the EWOD electrodes, and is therefore also used to physically contain the fluids of the device, and define the cell gap of the device.

This reference electrode is most ideally connected to the same drive electronics board as that which supplies the signals to the main EWOD substrate, so that if AC voltages are used (as is commonly the case), the frequency of the signal applied to the reference electrode matches that which is applied to the EWOD element. This allows the maximum voltage signal required from the EWOD substrate to be halved and this makes possible the usage of TFT electronics as drive electronics on a substrate of the EWOD device.

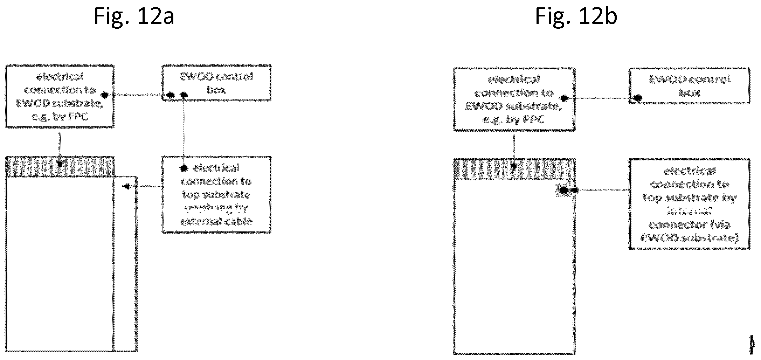

Connection from the main drive electronics to the reference electrode can be achieved externally (e.g. by using overlapping substrates and a cable, as shown schematically in Figure 12(a)), but is more neatly achieved by including a pad at the desired reference voltage on the lower substrate, and making an internal connection through to the reference electrode on the opposing (upper) substrate which spans the cell gap of the device, for example by using a blob of solder paste or other conducting material. Similar techniques are used for providing electrical connection in a liquid crystal display (LCD). Such an internal connection is illustrated in Figure 12(b). Such a connecting structure may be referred to as a 'top-plate via'.

In some devices it is desired for the top-substrate electrode to be more complex than a single reference electrode, so that it is necessary to make multiple independent electrical connections to the top substrate. To do this it is necessary either to go back to the in-elegant over-hang technique of Figure 12(a), or face the technical challenge of creating several top-plate vias. Creating multiple top-plate vias with a simple solder paste blob may be possible for a few electrodes but quickly becomes more challenging as the number of required electrical connections to the top-plate increases. In the extreme case the top-plate requires as many separate electrical connections as the EWOD substrate or perhaps more, e.g. several tens or even hundreds, and the required pitch of the connections becomes too small to allow the use of multiple solder paste blobs.

EP 3427832 proposes an EWOD device that includes a first and second substrate assemblies, and a spacer that spaces apart the first substrate assembly from the second substrate assembly to define a channel between them. The spacer defines fluid input ports that are in fluid communication with the channel, and the spacer is configured for directing fluid from the fluid input ports into the channel. The spacer has a combed spacer configuration to define the fluid input ports, including alternating teeth that extend into the channel from a base region, and the teeth isolate adjacent fluid input ports from each other. The spacer may contact only a portion of the first and second substrate assemblies to form a spacerless region within the EWOD device, and the spacer includes regions that are in contact with both the first and second substrate assemblies and extend into the channel to define a cell-gap of the channel.

US 2013/314625 proposes a touch sensing display panel that includes a first substrate, a second substrate, a touch sensing device, a patterned electrode layer, an insulating layer, and a sealant. The first substrate has a touch sensing region, and a sealant region surrounding the touch sensing region. The touch sensing device is disposed on an inner surface of the first substrate in the touch sensing region. The patterned electrode layer is disposed on the inner surface of the substrate in the sealant region, and the patterned electrode layer includes a plurality of connecting lines electrically connected to a touch sensing device, and an auxiliary electrode. The auxiliary electrode is not directly electrically connected to the connecting lines and the touch sensing device. The sealant is disposed between the first substrate and the second substrate in the sealant region, and at least one of the connecting lines and the auxiliary electrode overlap the sealant.

### STATEMENT OF PROBLEM BEING SOLVED

The present invention provides a microfluidic device, such as for example an electrowetting on dielectric (EWOD) device for example an active matrix electrowetting on dielectric (AMEWOD) device, that allows for more complex circuit configurations. A spacer or gasket used to retain the top and bottom plate elements at a fixed gap distance is also used to provide a conductive path between a circuit element disposed on a surface of the second substrate facing the fluid chamber and an associated terminal. In one aspect a gasket that forms a conductive bridge between a bottom plate element and a top plate element is used as a spacer to retain the top and bottom plate elements at a fixed gap distance. In further embodiments a spacer comprising a plurality of conductive circuit elements is provided, which spacer facilitates performance of more complex electrical measurements on droplets residing in the fluid chamber of the device within the AMEWOD device.

### SUMMARY OF INVENTION

Aspects of the present invention provide a microfluidic device and a method, as set out by the appended set of claims. According to a first aspect, the invention provides a microfluidic device comprising: a first substrate and a second substrate; a gasket spacing the first substrate from the second substrate in a thickness direction to define a fluid chamber between the first substrate and the second substrate, an inner edge face of the gasket defining a lateral boundary of the fluid chamber; a plurality of independently addressable array elements provided on a surface of the first substrate facing the fluid chamber; a plurality of circuit elements disposed on a surface of the second substrate facing the fluid chamber; and at least one port for introducing a fluid sample into the fluid chamber; wherein the gasket is configured to provide multiple independent electrically conductive paths extending at least in a plane of the gasket, each conductive path extending between a respective circuit element and a respective associated terminal along a direction transverse to the thickness direction. The terminals are provided on the gasket at a location spaced from the inner edge face of the gasket.

In an embodiment the gasket comprises a projecting portion that projects beyond the first substrate and the second substrate, and wherein the conductive paths extend to the projecting portion of the gasket.

In an embodiment an electrically conductive layer is provided on the surface of the second substrate facing the fluid chamber layer, the circuit elements being defined in the electrically conductive layer.

In an embodiment the gasket further provides a conductive path between a conductive member disposed in part of the inner edge face of the gasket and an associated terminal.

In an embodiment the inner edge face of the gasket is shaped to define the at least one port.

Another aspect of the invention provides a method comprising: introducing a fluid sample into the fluid chamber of a device of the above aspect; controlling the array elements provided on the first substrate of the device so as to move the fluid sample to be adjacent to the circuit element, or to a selected one of the circuit elements, disposed on the second substrate; and applying a voltage to the terminal associated with the circuit element or with the selected circuit element.

In an embodiment the method comprises applying the voltage to thereby charge the fluid sample.

In an embodiment the method comprises performing one or more further fluidic operations on the charged fluid sample may for example comprise separating at least one fluid droplet from the fluid sample.

In an embodiment the method comprises applying the voltage to thereby pass a measurement signal through the fluid sample.

As set out in further detail in the description of the embodiments, aspects of the invention can provide many advantages. In some examples the gasket (which also functions as a spacer) may be an isotropic gasket/spacer, in that, at a point in the gasket, the conductivity of the gasket has the same value in every direction. This embodiment may make it possible to use the spacer to pre-charge droplets immediately after loading into the microfluidic device, and so obtain better dispensing of droplets. It may also make it possible to detect the position of the spacer relative to array elements of the device, and so check that the device is correctly manufactured.

In other embodiments the gasket/spacer is an anisotropic spacer. In one case the spacer may be a spacer that conducts only, or at least preferentially, in one direction, such as a z-conducting spacer (as could potentially be achieved with a thick ACF film), or it could be a more complex circuit such as a gasket created using FPC methods of fabrication. The advantages described for an isotropic gasket/spacer apply to an anisotropic spacer, but the anisotropy provides further advantages. For example it is possible to provide multi-point electrical connection to the spacer and make possible top-plate resistance checking (this could not be done with a completely isotropic spacer, since a current path through the spacer would exist that would make such measurements impossible - although it could be effected using a spacer having two portions or more that were individually isotropically conducting but that were insulated from one another). A further advantage is that is possible to carry multiple pairs of sensing signals to and from the droplets via the top-plate substrate.

In further embodiments the gasket/spacer is again an anisotropic spacer, and is used for sensing purposes (that is, for sensing the location and/or properties of a droplet in the microfluidic device). The signal to/from the droplets may be carried out directly via the spacer, and not via the top-plate electrode, thereby avoiding the need to provide suitable circuits or tracks on the top-plate.

### BRIEF DESCRIPTION OF FIGURES

Fig. 1 depicts a prior art electrowetting on dielectric device.
Fig. 2 (a-g) depicts a plan view from above of an aspect of the invention that represents the loading and subsequent dispensing of droplets from a fluid reservoir, where sample is loaded along an edge of an upper substrate.
Fig. 3 (a-e) depicts a plan view from above of an aspect of the invention that represents the loading and subsequent dispensing of droplets from a fluid reservoir, where sample is loaded through an aperture in the surface of an upper substrate.
Fig. 4 (a-f) depicts a plan view from above of an aspect of the invention where additional conductive circuits are provided on an upper substrate and are tracked through the upper substrate to corresponding electrode pads on the lower substrate.
Fig. 5a - 5e depicts a plan view from above of an aspect of the invention similar to that shown in Fig. 4, except that the tracking takes place within the gasket of the device instead of through the upper substrate.
Fig. 6a and 6b depicts a plan view from above of a further aspect of the invention, where conductive pathways within the gasket does not lead to electrode pads on the lower substrate, but rather pass directly out of the device to an external connector.
Fig. 7a-7b depicts a plan view from above of a further aspect of the invention, in which an anisotropic gasket provides for electrical contact to both lower and upper substrates.
Fig. 8(a-d) depicts a plan view from above of a further aspect of the invention, where a patterned top substrate over hangs an edge of the device, and where electrical contact is made to between the top substrate and an instrument via a flexible printed circuit element.
Fig. 9(a-b) depicts a plan view from above a further aspect of the invention in which there are no electrode patterns on the upper substrate, because the electrical signals to/from the droplets are carried directly via the gasket rather than via the upper substrate electrodes.
Figure 10(a) and 10d depicts a plan view from above a further aspect of the invention in which the gasket is multi-layered to allow for either pre-charging of the droplets within the device or for electrical shielding of the upper substrate electrodes from the circuitry on the lower substrate, or both.
Fig. 10b and 10c depict partial cross-sections through the EWOD of figure 10a.
Figs 11a and 11b are schematic sectional views through EWOD devices. The embodiment of Fig.11a does not fall under the scope of the claims.
Figs. 12a and 12b are schematic illustrations of two known techniques for making an electrical connection to an upper substrate of a microfluidic device.
Fig. 13 illustrates another application of an EWOD device according to the invention.

### DESCRIPTION OF EMBODIMENTS

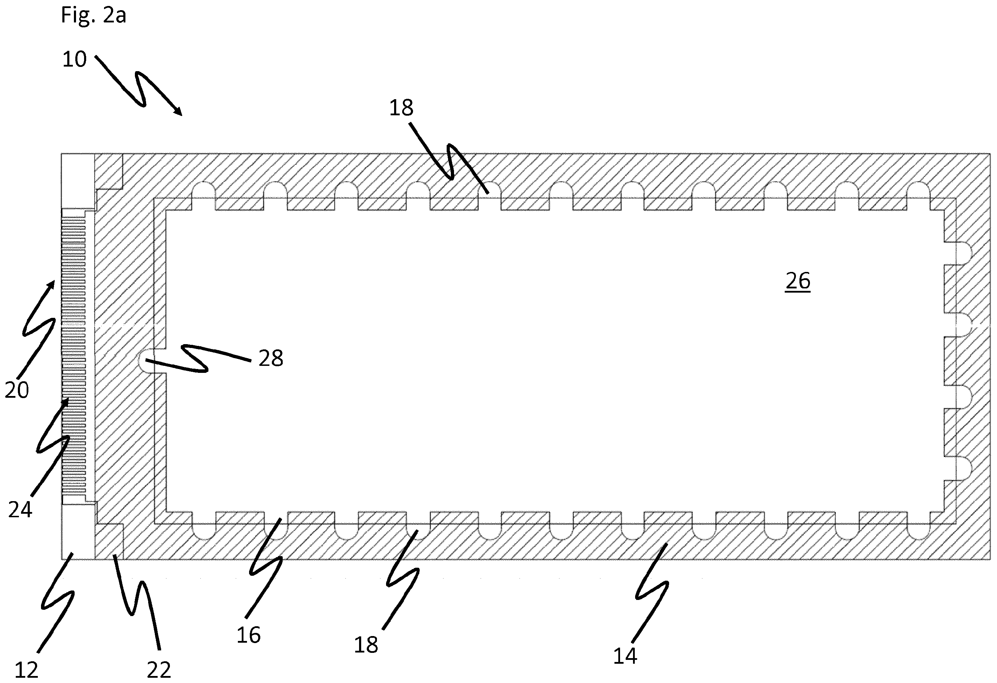

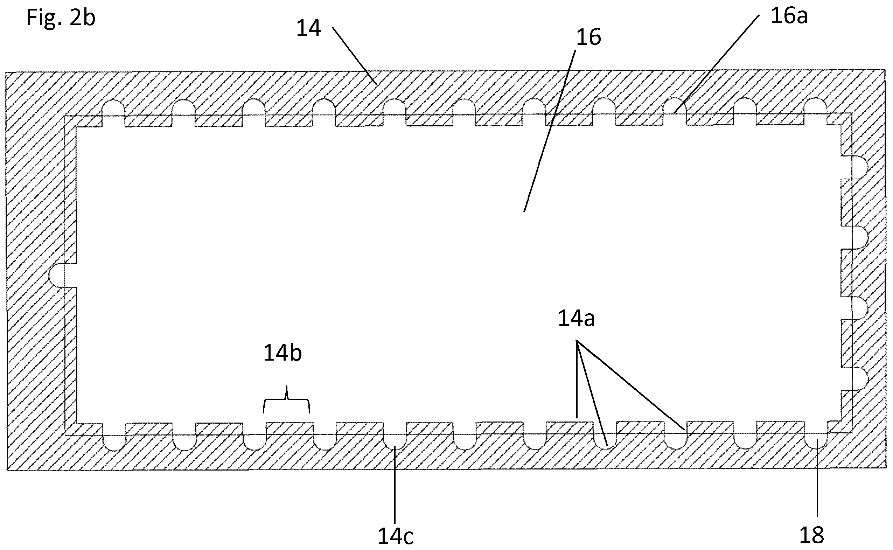

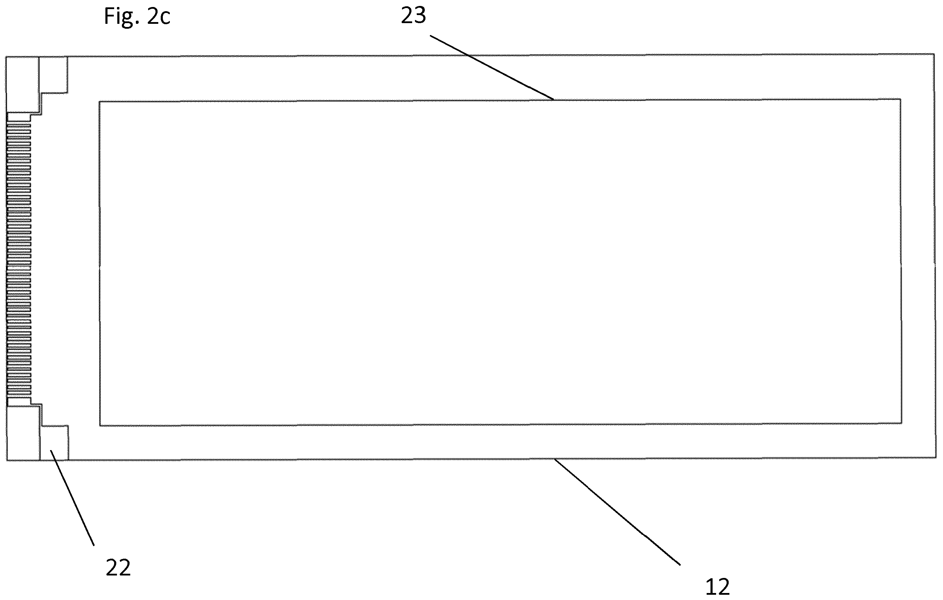

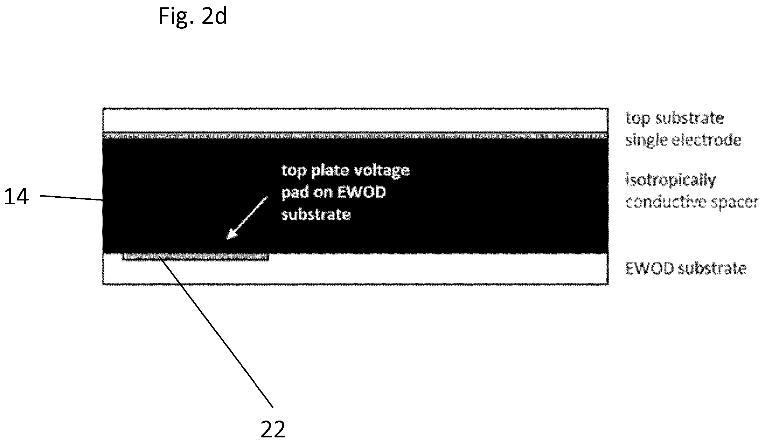

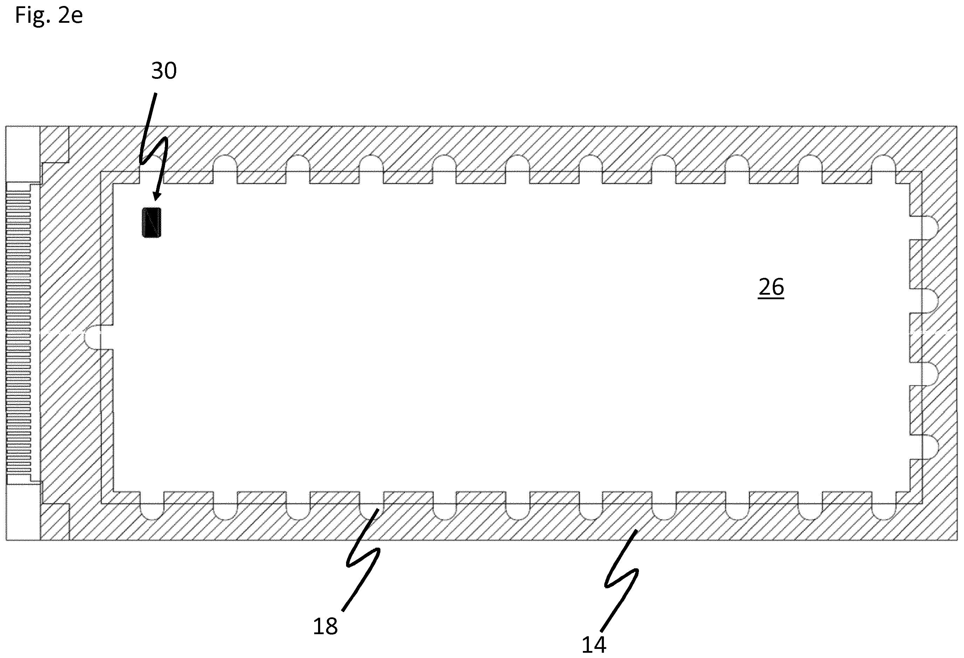

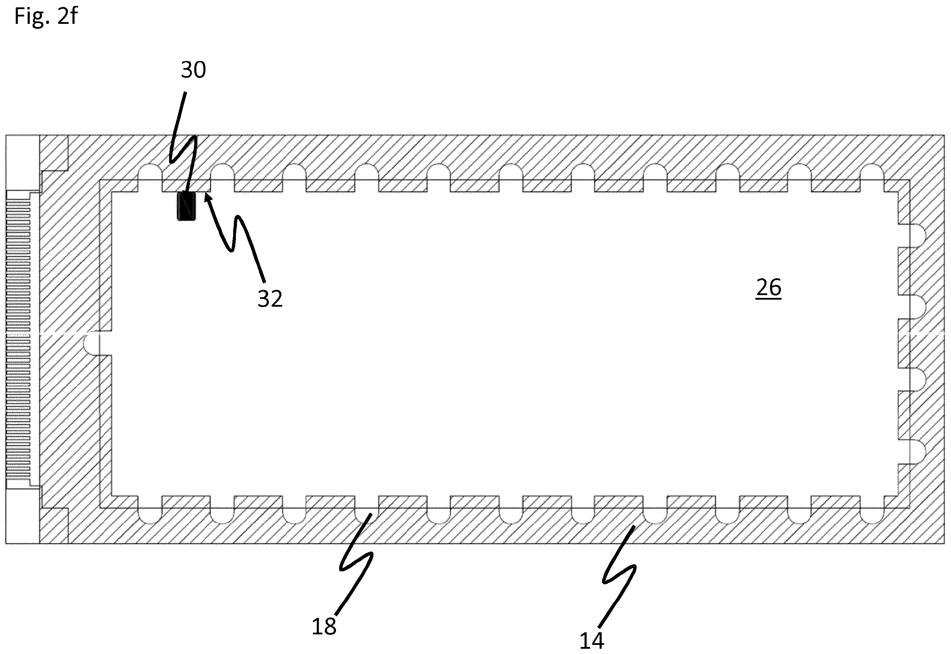

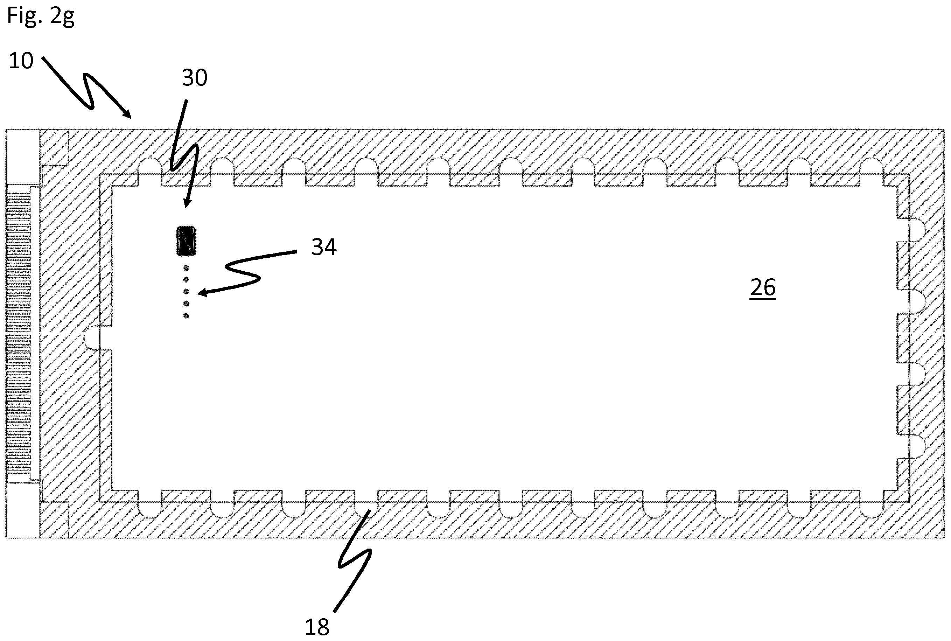

Fig.2 (a-g) represents a plan view from above of an aspect of the invention wherein an isotropic gasket is used to create a gap between the upper and lower plates of an AMEWOD device.

Fig. 2a shows a plan view from above of an exemplary AMEWOD device (10) according to an aspect of the invention, where a liquid sample is introduced to the device along an edge of an upper substrate. AMEWOD device (10) comprises a lower substrate (12), a gasket (14), upper substrate (16), port (18, 28), edge connector (20) and contact pad (22). For clarity, Fig 2b shows the gasket (14) and upper substrate (16) only, and fig 2c shows the lower substrate only. Line 23 in figure 2c denotes the boundary of the active area of the device.

The fluid chamber of the EWOD device corresponds to the aperture or bore in the interior of the gasket. The boundaries of the fluid chamber are defined by the lower substrate, the upper substrate, and the inner edge face of the gasket.

Edge connector (20) comprises a plurality of contacts (24). Typically, AMEWOD device (10) comprises a plurality of ports (18) through which liquid samples (typically polar liquid samples) may be applied and a single port (28) through which a filler fluid (not shown) may be applied. A filler fluid is typically a non-polar fluid, non-limiting examples of which include silicone oil, fluorosilicone oil, pentane, hexane, octane, decane, dodecane, pentadecane, hexadecane, which may generally be referred to as oil. According to the aspect of Fig. 2, ports (18,28) are defined by edge profile features of gasket (14) and the edge (16a) of upper substrate (16). Ports (18, 28) thus allow liquid sample to be loaded into the cavity (26) defined between lower substrate (12) and upper substrate (16), the height of which gap is defined by the thickness of the gasket (14). The aperture through which liquid sample enters is therefore defined by the inner edge face 14a of the gasket and the outer edge 16a of the upper substrate (16).

In the embodiment of figs 2a-2c, as shown in fig 2b the inner edge face 14a of gasket 14 that is provided with edge profile features that comprise inwardly (that is, towards the interior of the fluid chamber) directed protrusions 14b that, when the AM-EWOD device is assembled, are overlaid by the upper substrate 16, whereas regions of the gasket between two neighbouring protrusions are not overlaid by the upper substrate 16 thereby forming a fluid input port 18, 28. (Alternatively, the gasket can be considered as having indentations 14c defined in its inner edges 14a.) The inner edge 14a of the gasket and the edge 16a of the upper substrate are not limited to the specific arrangement shown in fig. 2a or 2b, and other arrangements may be used, provided that at least one of the inner edge 14a of the gasket and the edge of the substrate is not straight, so that there is at least one region of the gasket that is not overlaid by the upper substrate 16 thereby forming a port 18. Figure 2b shows the fluid chamber as generally rectangular with the inner edge face 14a of the gasket defining a generally rectangular circumference for the fluid chamber, but the invention is not in principle limited to a rectangular fluid chamber.

Lower substrate (12), the inner edge face 14a of the gasket (14) and upper substrate (16) define a cavity (26) therebetween, which has a height, h, determined by the thickness of gasket (14), and a width, w, and length, l, defined by the inner edge length dimensions. Where h preferably is at least about 25um, at least about 50um, at least about 75um, at least about 100um, at least about 150um, at least about 200um, at least about 250um, at least about 300um, at least about 400um, at least about 500um, at least about 600um, at least about 700um, at least about 800um, at least about 900um, at least about 1000um; w preferably is at least about 5mm, at least about 7.5mm, at least about 10mm, at least about 12.5mm, at least about 15mm, at least about 17.5mm, at least about 20mm, at least about 22.5mm, at least about 25mm, at least about 27.5mm, at least about 30mm, at least about 32.5mm, at least about 35mm, at least about 37.5mm, at least about 40mm, at least about 50mm; at least about 55mm, at least about 60mm, at least about 65mm, at least about 70mm, at least about 75mm, at least about 80mm, at least about 85mm, at least about 90mm, at least about 95mm, at least about 100mm, at least about 125mm, at least about 150mm, at least about 175mm, at least about 200mm. I preferably is at least about 10mm, at least about 15mm, at least about 20mm, at least about 25mm, at least about 30mm, at least about 35mm, at least about 40mm, at least about 45mm, at least about 50mm, at least about 55mm, at least about 60mm, at least about 65mm, at least about 70mm, at least about 75mm, at least about 80mm, at least about 85mm, at least about 90mm, at least about 95mm, at least about 100mm, at least about 125mm, at least about 150mm, at least about 175mm, at least about 200mm. In use, cavity (26) is generally filled with oil before a polar liquid sample is applied to the device.

In this embodiment the gasket 14 is an isotropic electrically conductive gasket (14). The gasket is formed of a conductive material, examples of which include a metal, or carbon, or a material containing metal or carbon particles. Generally, in order to make electrical contact between the upper and lower substrates, there must be some media to connect the bulk of the gasket material to the surfaces. For example, the gasket could be a double-sided carbon tape which includes a conductive adhesive on both sides of the tape, such is used for mounting samples for SEM measurements. Alternatively, the gasket could consist of a non-adhesive metal layer that makes electrical contact to the upper and lower substrate via a conductive adhesive or paste such as a silver loaded paint or glue. The gasket is generally uniform with respect to the structural composition thereof, particularly with respect to the distribution of the conductive component thereof, such that a current is able to pass freely throughout the thickness thereof. Isotropic gasket (14) forms a conductive pathway between contact pad (22) and the at least one conductive element (not shown) on upper substrate (16).

Lower substrate (12) has a first major surface on which is disposed at least one conductive element, covered by a dielectric insulation layer, and a hydrophobic layer (not shown). The at least one conductive element is connected to at least one contact (24) of edge connector (20). (In the case of an AM-EWOD device, multiple array elements each having an associated element electrode are typically provided on the lower substrate. Each array element is connected to one or more contacts of the edge connector 20.) Contact pad (22), which is not covered by the dielectric and hydrophobic layers, is conductively connected to a contact (24) of edge connector (20), for example a PCB (printed circuit board) connector. Upper substrate (16) has a major surface on which is disposed at least one conductive element, which is covered by a layer of hydrophobic material (not shown). The at least one conductive element on upper substrate (16) lacks a hydrophobic layer at a point that contacts isotropic gasket (14). Isotropic gasket (14) therefore forms a conductive path between a contact (24) of the edge connector 20 on the lower substrate, through contact pad (22), to the at least one conductive element on upper substrate (16). (As shown in figure 2a, the gasket 14 does not overlay any of the other connectors 20 of the edge connector 24.) The respective surfaces of lower substrate (12) and upper substrate (16) having conductive elements thereupon are held in opposing facing arrangement, a gap distance apart defined by isotropic gasket (14). This is illustrated in fig. 2d which is a part cross-sectional view through the device of figure 2a (the dielectric layers, insulation layers and the contact 24, edge connector 20 are omitted from figure 2d for ease of explanation).

When a droplet of liquid, for example a polar liquid, such as for example a saline solution, is present within cavity (26), a capacitively coupled circuit is formed when the droplet forms a bridge between the respective conductive elements on lower substrate (12) and upper substrate (16). Such a droplet may thus be susceptible to control by electrowetting as described in, for example, US patent publication 2018/0284423.

Figs. 2e-g show the AM-EWOD device of Fig. 2a, following introduction of a liquid sample (30) into the fluid chamber 26 through a port (18 or similar) of AMEWOD device (10), the fluid chamber having previously been at least partially filled with oil via port (28). Liquid sample (30) may be introduced through port (18) using a pipette or a syringe (not shown), for example. Initially (Fig. 2e), following application of liquid sample (30) through a port (18), liquid sample (30) may be transferred into cavity (26) by electrowetting. A microprocessor (not shown) may be configured using a script to operate a protocol intended to control the movement of a sample of polar liquid by electrowetting.

Once liquid sample (30) has entered cavity (26) it may be moved by electrowetting to contact an edge element (32) of isotropic gasket (14) that is exposed within cavity (26) (Fig. 2f). A charging voltage may be applied to liquid sample (30) when it is in contact with edge element (32) of isotropic gasket (14). Such a charge voltage may be applied between a conductive element of the lower substrate (12) (such as an array element electrode) and edge element (32) of isotropic gasket (14). Once liquid sample (30) has become charged following contact with edge element (32), it may be moved by electrowetting to another location within cavity (26). US 15/661,609, filed on 27 July 2017, published as US 2019/0030537 A1, describes an electrowetting on dielectric (EWOD) device having a pre-charging structure for pre-charging a fluid reservoir.

Fig. 2g represents the dispensing of individuals droplets (34) from liquid sample (30), following charging of liquid sample (30) upon contact with edge element (32). The charging of liquid sample (30) through contact with edge element (32) can alter the surface tension characteristic of the interface between liquid sample (30) and the oil used to fill cavity (26). When an electrowetting "dispense" sequence is applied to the AMEWOD device (10) by a microprocessor (no shown) configured by a script, the efficiency with which droplets (34) are separated from the liquid sample (30) is improved, when compared with a liquid sample that has not been charged upon contact with edge element (32). The beneficial effects of liquid sample charging may vary based on the composition of the liquid sample.

In a variant (not shown) the gasket shown in Figure 2(b) is not electrically continuous around its perimeter of the device, but is made up of two conductive parts that are insulated from one another (for example using a non-conductive adhesive), with each part attached to one of the top-plate via structures 22 on the lower substrate. In this embodiment, it is still possible to perform a continuity test remotely from the edge connector - through one via, through the common electrode, and back through the other via 22 to another terminal of the edge connector - so that the electrical connection to the top-plate may be tested.

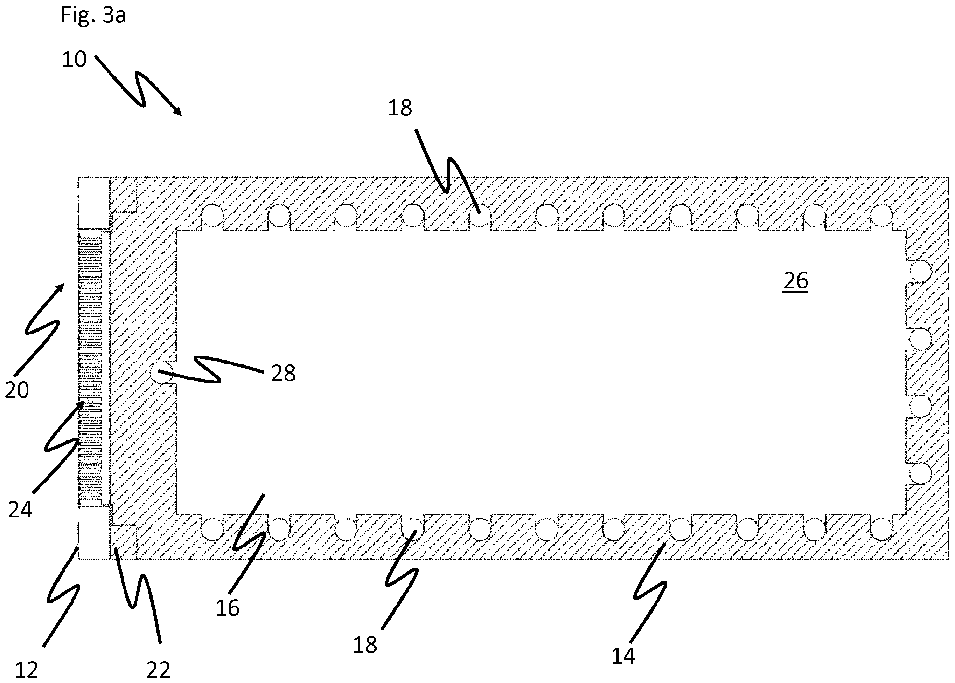

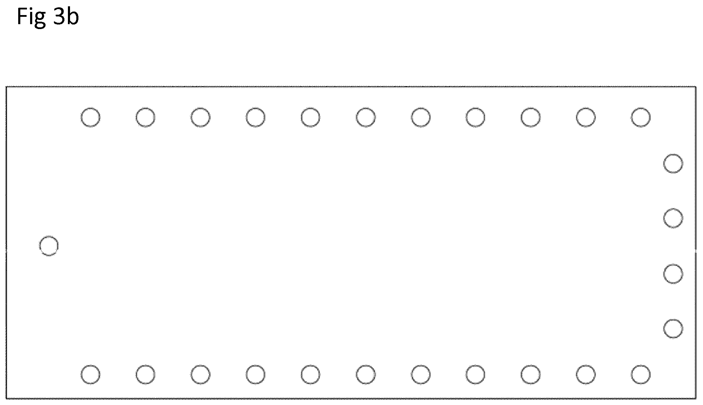

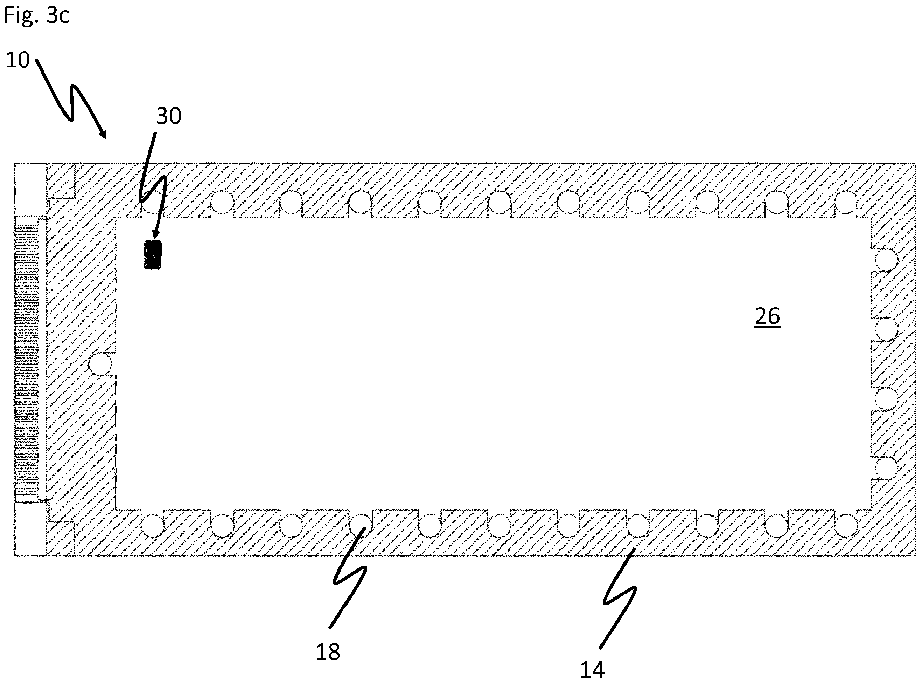

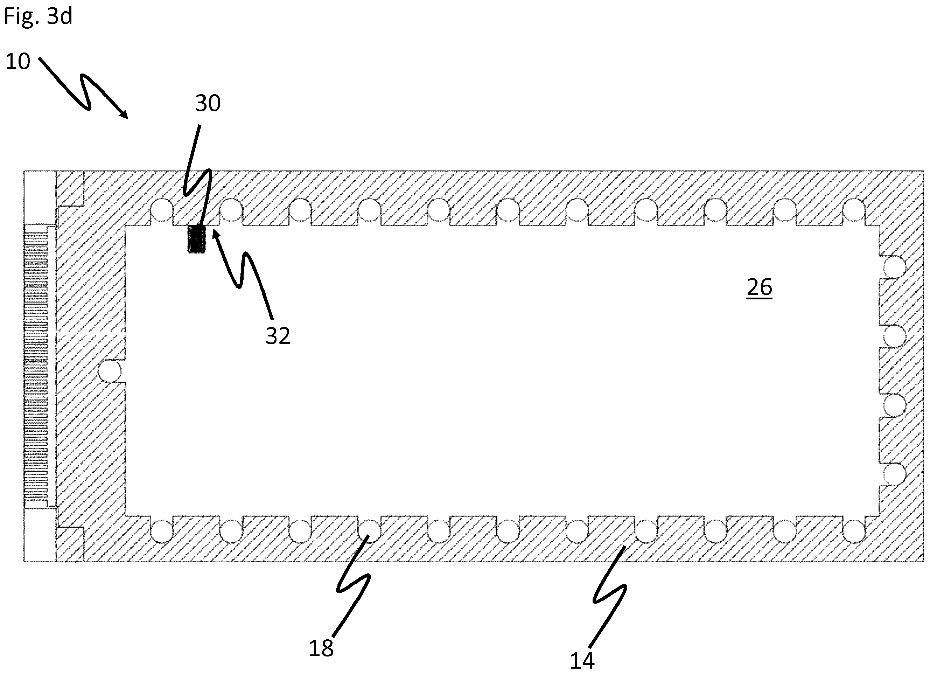

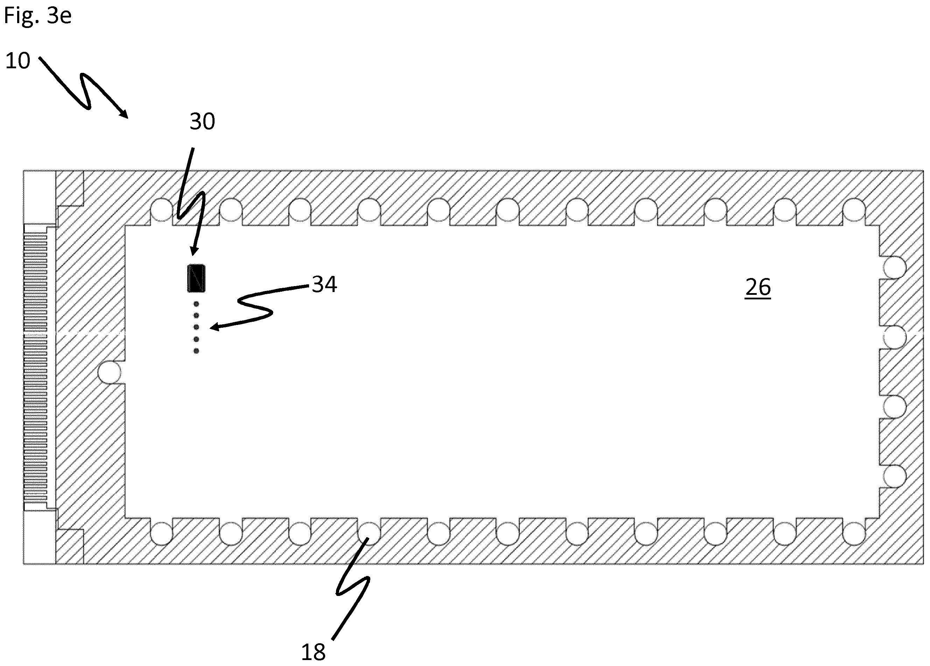

Figs. 3(a-e) represent a further aspect of the invention, in which a liquid sample is applied to an AMEWOD device (10) through one or more apertures in the surface of an upper substrate. In such an aspect one or more apertures 18 are provided within upper substrate (16) which align with edge profile features along the inner perimeter of isotropic gasket (14). Fig 3a is a plan view of a device according to this embodiment, and fig. 3b shows the upper substrate separately, for ease of explanation. The gasket 14 and lower substrate of this embodiment correspond generally to the gasket 14 and lower substrate of figs. 2c and 2b respectively.

A liquid sample therefore may enter the AMEWOD device (10) through an aperture in upper substrate (16) (when compared with ports (18, 28) of the aspect depicted in Fig. 2). As depicted in Fig. 2a-c, upper substrate (16) had a length and width less than the length and width of isotropic gasket (14), such that the edges of upper substrate (16) bisected the edge profile features of isotropic gasket (14) around the inner edge of the gasket which defines cavity (26). According to the aspect of the invention depicted in Fig. 3, upper substrate (16) has a length and width equivalent or substantially equivalent to those of the isotropic gasket (14).

Fig. 3a depicts a plan view from above of an AMEWOD device (10) according to this further aspect of the invention, prior to introduction of a liquid sample. Ports (18, 28) are disposed around the perimeter of upper substrate (16), in such a way they coincide with regions between neighbouring edge profile features of isotropic gasket (14). Ports (18, 28) are typically provided by drilling a hole through the substrate. The hydrophobic coating (not shown) applied to upper substrate (16) is removed in at least one region coinciding, in the assembled device, with the gasket (14) thereby forming a conductive pathway from the contact (22) on the lower substrate (which is connected with a respective terminal of the edge connector) to the at least one conductive element on the surface of upper substrate (16) in contact with isotropic gasket (14).

Figs. 3(c-e) depict the progress of a liquid droplet (30) introduced to AMEWOD device (10) through aperture (18 or similar) in the surface of upper substrate (16). Liquid droplet (30) is initially moved by EWOD into cavity (26) once it has been applied through port (18) (Fig. 3c) before liquid droplet (30) is moved to contact edge element (32) of isotropic gasket (14) (Fig. 3d). While in contact with edge element (32), a voltage is applied to liquid droplet (30) to charge the droplet. Once liquid droplet (30) has been charged, following contact with edge element (32), it is again moved by EWOD to a further location within cavity (26) (Fig. 3e). A microprocessor configured to operate a script (not shown) causes droplets (34) to be dispensed from liquid sample (30). Droplets (34) may then be used for further reaction processes or schemes within AMEWOD device (10), according to the intended use thereof.

In the embodiments of figures 2 and 3, the gasket 14 is "isotropic", in that it is made of a bulk conductive material so that the conductivity at a point in the gasket has the same value, or substantially the same value in every direction (and typically may also be uniform, or generally uniform, over the whole of the gasket). In other embodiments the gasket is not isotropic, and the conductivity of the gasket is in some sense anisotropic - for example, the conductivity may vary over the volume of the gasket so as to define independent conductive pathways that are separated by insulating regions, or the gasket may be made of a material that conducts only, or at least preferentially, in one direction.

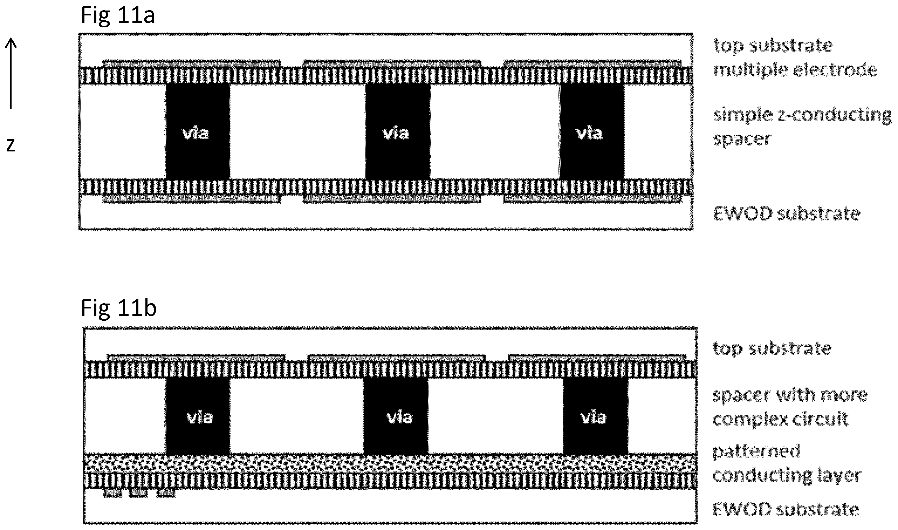

Fig 11a is a cross sectional view through a microfluidic device not according to the invention having a gasket made of a material that conducts in the z direction (the vertical direction in fig. 11a) but not along the x- and y- direction - this is known as a "z-conducting spacer". There are multiple electrodes on the top substrate, which are addressed by a corresponding set of electrodes on the lower substrate (referred to as "EWOD substrate" in figure 11a) which may be connected to respective terminals of a connector on the lower substrate (such as an edge connector similar to those in Figs 2 and 3). The gasket has minimal conductivity in directions perpendicular to the z-direction, otherwise it would short the electrodes together. The gasket thus provides via regions that electrically connect an electrode on the upper substrate to a corresponding electrode on the lower substrate, while ensuring that an electrode on the upper substrate is insulated from other electrodes on the lower substrate. Such an anisotropic gasket could be achievable through the use of anisotropically conductive films (ACF) or pastes (ACP), either on their own (so the gasket is formed in bulk of anisotropically conductive material) or in conjunction with constructional features of the gasket, which allows for conduction in one direction only. Another way of making an anisotropic gasket could be through conventional methods used for making FPC (flat printed circuits) where the vias are made from copper and the insulating portions in between are made from Kapton^{™}.

Figure 11b shows an embodiment in which the 'x-y' positions of the electrodes on the two opposing substrates do not match, and hence the gasket needs a more complex design in order to provide conductive paths 'x-y' routing of the connections that extend in the plane of the gasket (the x-y plane) so as to provide electrical connection between electrodes on one substrate and those on the other substrate, as well as extending in the z-direction (the thickness direction of the gasket). This may for example be achieved by providing a patterned conductive layer, such as an FPC, that provide an electrical connection from an electrode on the lower substrate to a point on the lower substrate below the corresponding electrode on the upper substrate. Electrical connection to the electrodes on the upper substrate is completed by vias provided in the gasket, for example by use of a gasket formed of a material that conducts in the z-direction but not in the x- and y-directions or by other techniques described herein.

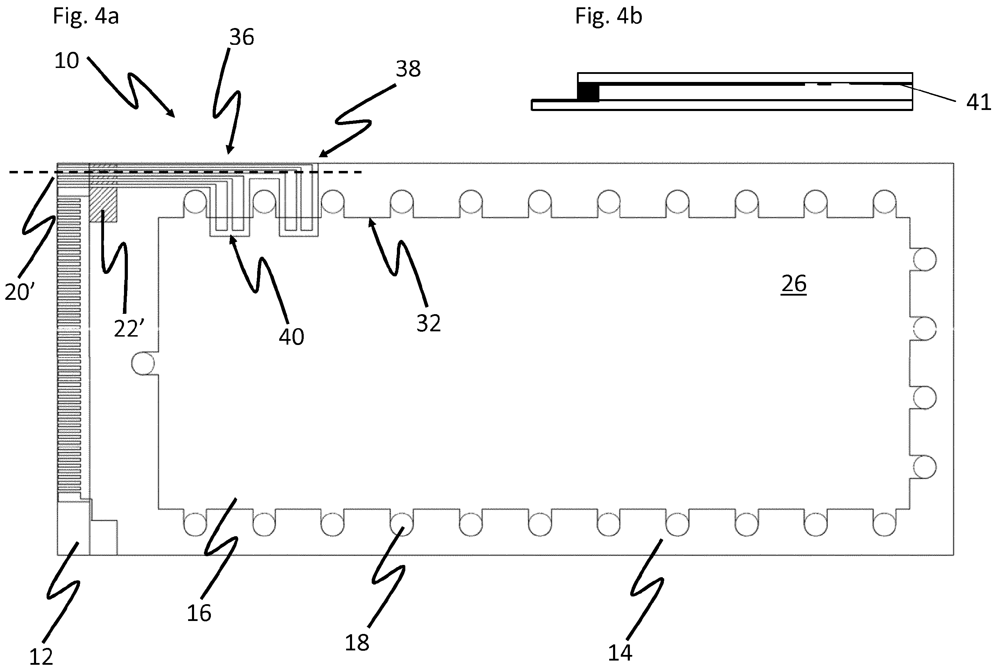

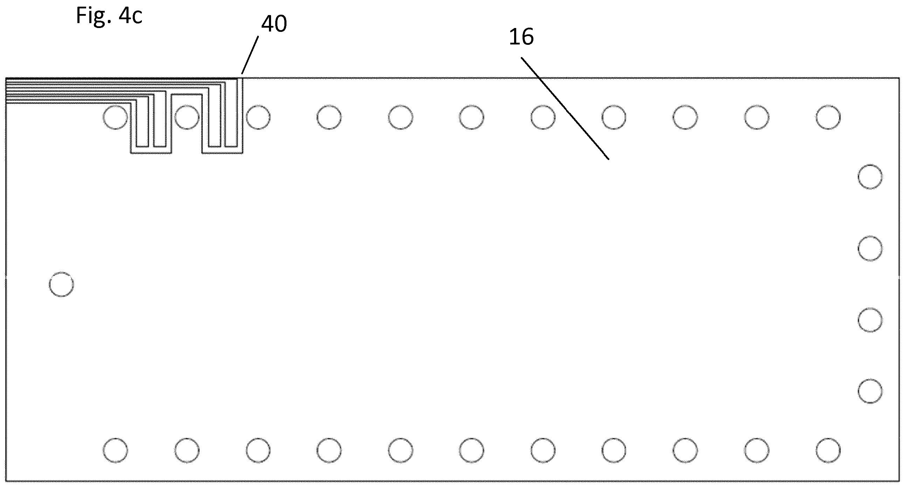

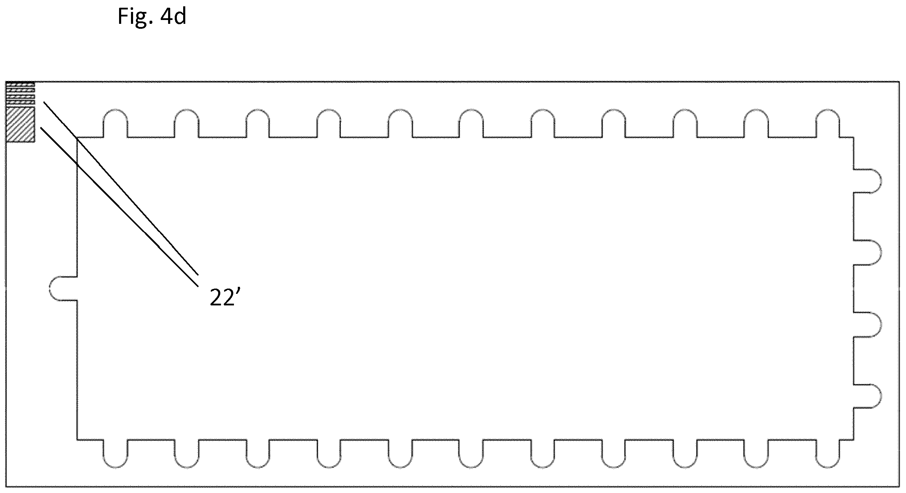

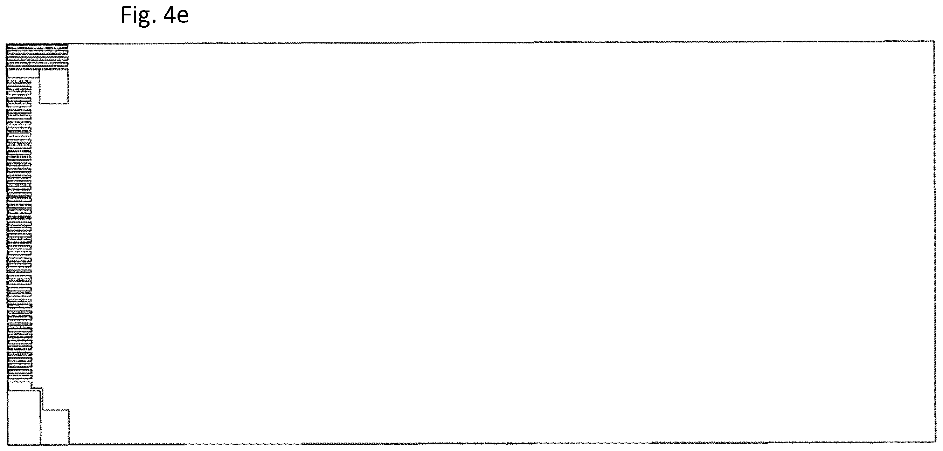

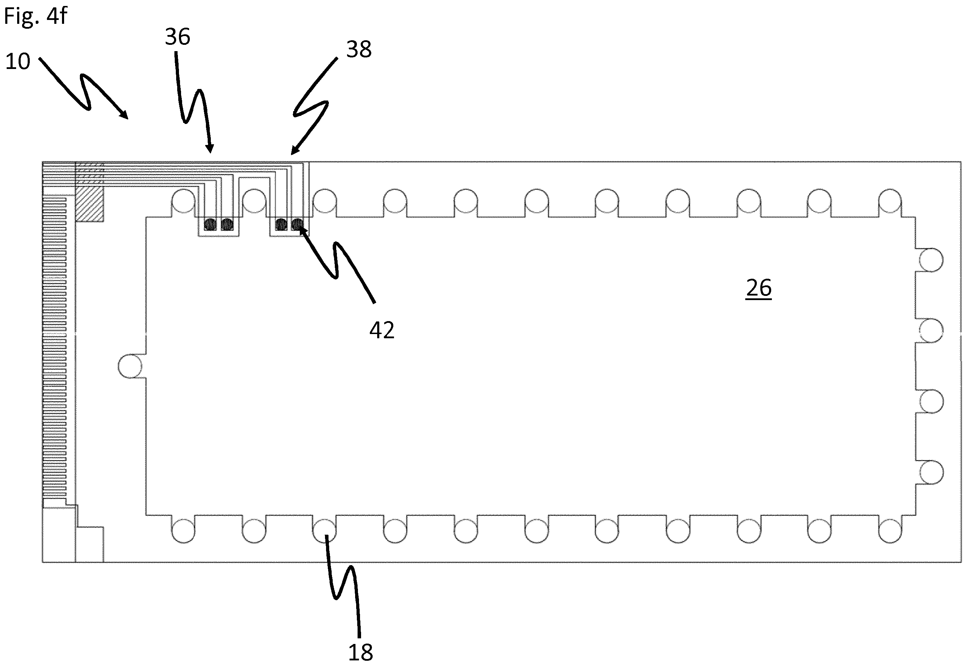

In yet a further aspect of the invention, an AMEWOD device (10) is depicted in plan view from above with respect to Fig. 4(a-f). Fig. 4a generally depicts an AMEWOD device (10) similar to the aspect depicted in Fig. 3, with certain modifications. Fig 4b is a cross-section through the device of fig 4a along the broken line showing in fig 4a. As depicted in Fig. 4a, upper substrate (16) extends to the outer dimension of isotropic gasket (14).

Upper substrate (16) is shown separately in figure 4c. As shown in figs 4a and 4c, the upper substrate comprises an array of electrode pairs (36, 38) which may be provided around the edge thereof. As shown in figure 4b, a conductive layer 41 may be deposited over the surface of the upper substrate 16, and this conductive layer may be patterned to define the electrode pairs. The remaining portion of the conductive layer may be used to provide a continuous conductive element, such as a common electrode. As shown in figures 4a and 4c, the electrodes of the electrode pair(s) project beyond the gasket into the fluid chamber. Figures 4a and 4c show the electrodes of the electrode pairs extending approximately perpendicular to the boundary of the fluid chamber, but the embodiment is not limited to this. The electrodes of the electrode pair(s) also comprise (or are connected to) respective conductive tracks that extend to an edge of the upper substrate. In the depiction of Fig. 4a, two pairs of electrodes (36, 38) are shown for simplicity, although it will be appreciated that fewer or more pairs of electrodes (36, 38) may be provided. For example, a pair of electrodes may be provided to coincide with each edge profile element (32) of gasket (14). It will be further appreciated that multiple pairs of electrodes (36, 38) may be provided on a single edge profile element (32), or in permutations thereof, wherein, for example, an edge profile element may comprise a single pair of electrodes, an edge profile element may comprise two or more pairs of electrodes and yet another edge profile element may have no pair of electrodes. In yet a further aspect a common terminal, such as a negative terminal, may be implemented that acts as a pair to a plurality of separate positive terminals.

As shown in figure 4d, the gasket is provided with conductive portions 22' that, when the device is assembled, contact respective ones of the conductive tracks on the upper substrate and also contact corresponding conductive tracks on the lower substrate (shown separately in figure 4e). Thus, electrodes of the pairs of electrodes (36, 38) may be electrically bonded, through respective conductive bridges (22') to contacts of an extended edge connector (20') on the edge of lower substrate (12) for connection to a controlling instrument (not shown). Upper substrate (16) in proximity of cavity (26) may comprise a continuous conductive element as described herein above, with the exception being that regions around electrode pairs (36, 38) may comprise insulated regions (40) so that electrodes of the electrode pairs are electrically isolated from one another and from the continuous conductive element.

Each respective pair of electrodes (36, 38) may be used for a range of purposes, including, but not limited to i) make electrochemical measurements, such as amperometric or potentiometric measurements, of a droplet; ii) apply a charging voltage to a droplet; iii) to determine an impedance characteristic of a droplet. Fig. 4f depicts presence of droplets (42) at each respective electrode of pair of electrodes (36, 38). A characteristic of each droplet (42) may be determined accordingly, by appropriate measurement process or a charging voltage may be applied to such a droplet.

Schlicht et al. (Scientific Reports, (2015) v5 pp9951) describe "Droplet-interface-bilayer assays in microfluidic passive networks". In a further aspect of the present invention, respective pairs of droplets (42) may be manipulated by EWOD to touch and thereafter form stable droplet interface bilayers (DIBs). Such pairs of droplets may then be moved by EWOD to contact a respective pair of electrodes (36, 38). Once a pair of droplets (42) that have formed a DIB are held in contact with pair of electrodes (42), with a respective droplet in contact with a respective electrode, a circuit is formed across the DIB interface. Electrode pair (36, 38) are thus used to monitor the transfer of a solute from one droplet to another droplet across the DIB interface, detected as a change in the current that flows when a fixed voltage is applied between pair of electrodes (36, 38).

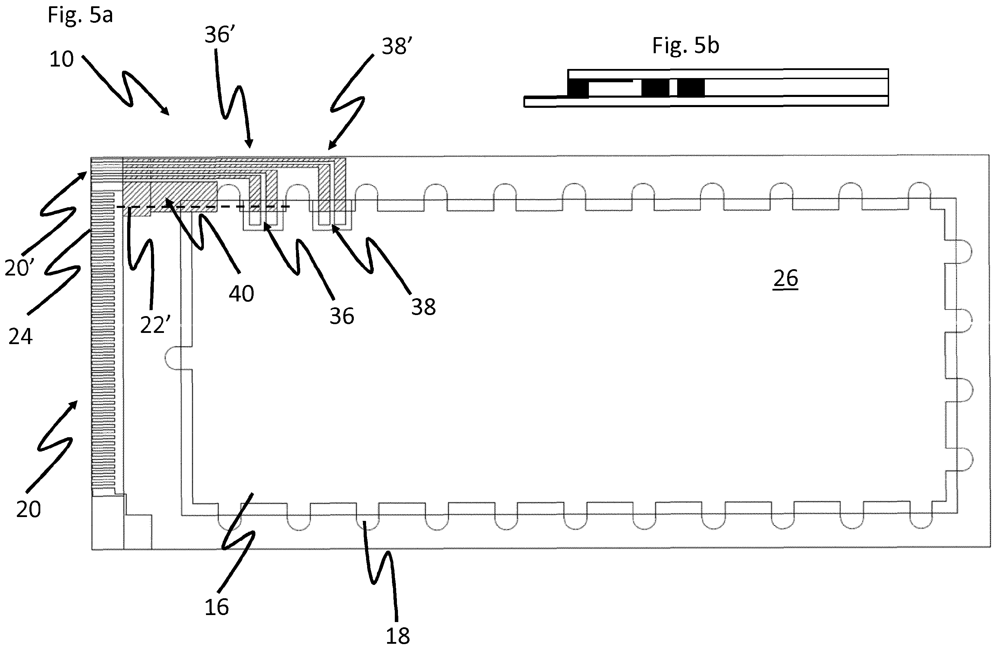

In an alternative embodiment, the necessary conductive pathway of the electrodes between the measurement pads on the upper substrate (that make contact with the droplets) and the corresponding pads on the lower substrate are made via conductive tracks provided within the gasket, as opposed to tracks within the upper substrate to pads that are vertically aligned between the upper and lower substrate (as in Figure 4). This embodiment is illustrated in Figure 5a - 5e. Fig 5a is a plan view from above of an EWOD device according to this embodiment, which shows the case where the upper substrate (16) is provided with a length and width dimension smaller than isotropic gasket (14) such that as described with respect to Fig. 2, such that the edges of upper substrate (16) bisect the edge profile features of isotropic gasket (14) around the inner edge of the gasket which defines cavity (26). Port (18) is therefore defined by the edge of upper substrate (16) and the edge feature of isotropic gasket (14).

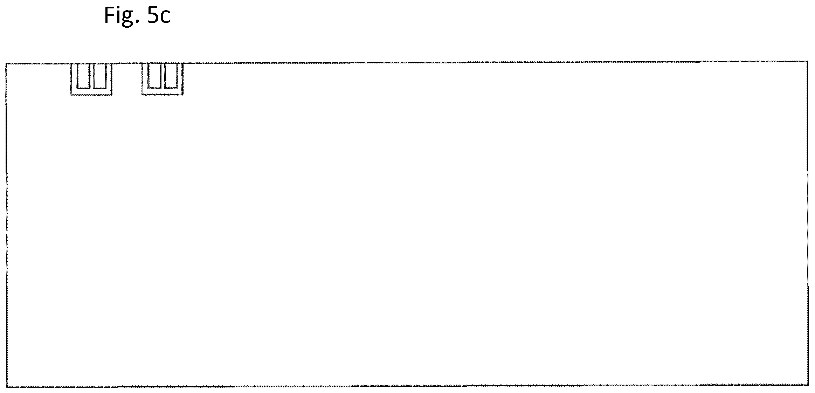

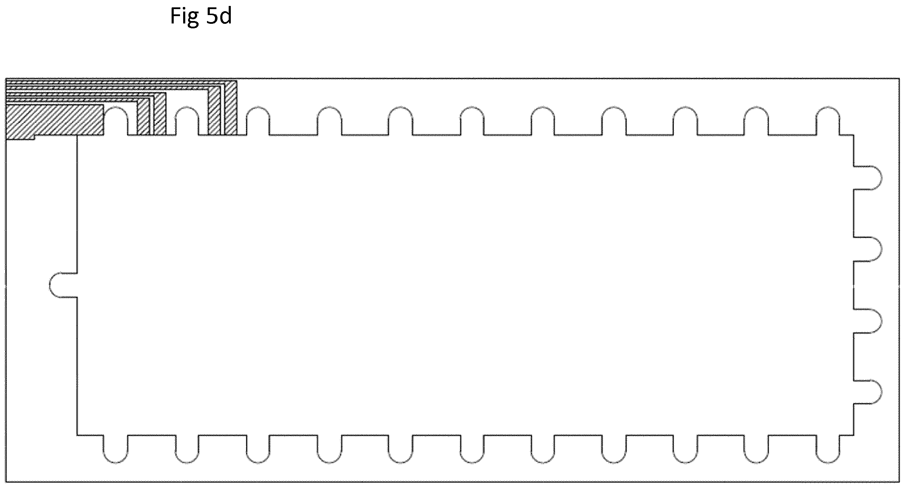

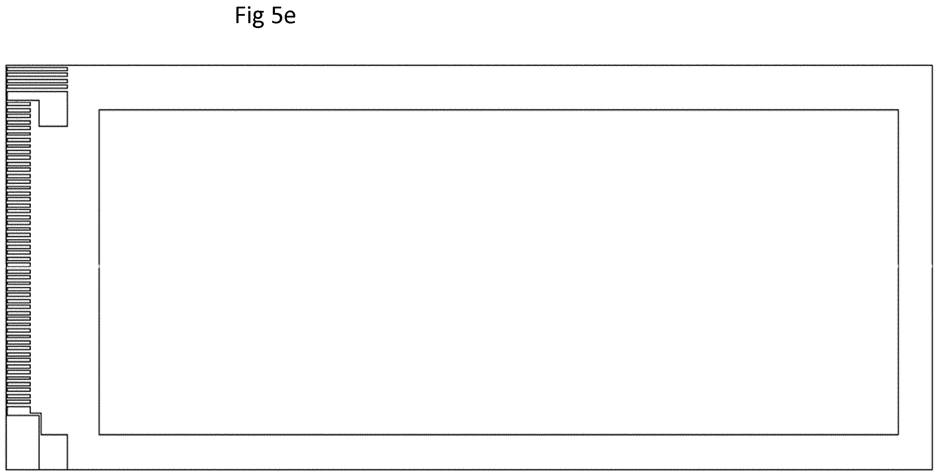

Pair of electrodes (36, 38) as depicted in Fig. 5a are constructed differently to the aspect depicted in Fig. 4. The portion of each pair of electrodes (36, 38) exposed on upper substrate (16) which extend into cavity (26) are produced similarly to those of Fig. 4, in as much as they are defined within the conductive layer disposed over the surface of upper substrate (16) that faces lower substrate (12), as shown in fig. 5c which is a plan view of the upper substrate. Electrode pair tracks (36', 38') are however provided in/on gasket (14), as shown in fig. 5d which is a plan view of the gasket. When the device is assembled, the electrode tracks provided in/on the gasket are in electrical contact with electrode pair (36, 38) on upper substrate (16) and to terminals of an extended edge connector (20') on lower substrate (12) through conductive bridge (22'). (If desired the respective parts may be directly bonded together, but they do not need to be physically bonded together as long as a conductive path exists between them.) The lower substrate is shown in plan view in figure 5e (the inner rectangle in figure 5e denotes the boundary of the fluid chamber). The electrical connection between the electrode tracks provided in/on the gasket, the electrode pair (36, 38) on upper substrate (16), and the terminals of the extended edge connector (20') on the lower substrate is also shown in fig.5b, which is a partial cross-section through the EWOD device along the broken line shown in figure 5a.

In the structures described so far, the goal has been to connect one or more electrodes on the upper substrate to corresponding terminals on the lower substrate, and this has been achieved through gaskets of different types. One reason for doing this is so that a single electrical connection can be made between the electronic boards within the instrument driving the device and the lower substrate - electrical connections to components on the upper substrate are made from terminals on the lower substrate via the gasket, and there is no need to provide terminals for connection to the instrument on the upper substrate. This electrical connection can be made in a variety of ways, including a Flexible Printed Circuit (FPC) connector or a Printed Circuit Board (PCB) connector. If the number of contacts (24) within edge connector (20) are so numerous that the width of each respective contact (24) and the space therebetween becomes too narrow, successful electrical contact between each respective contact (24) and a receiving connector in an instrument (not shown) may be compromised. In such instance, one or more additional edge connectors (not shown) may be provided on another edge (such as for example a long edge) of lower substrate (12).

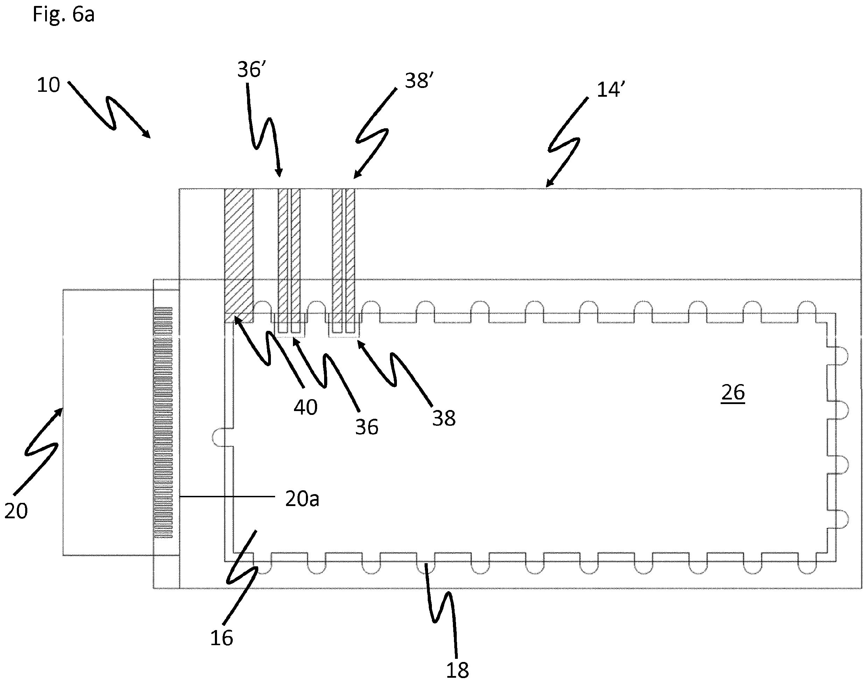

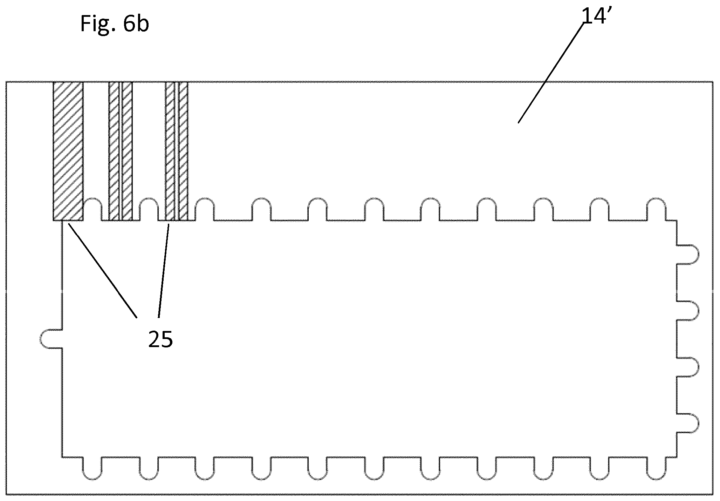

Alternatively, electrical connection to a component on the upper substrate may be done directly through conductive paths within anisotropic gasket (14'). Rather than passing a circuit from the upper substrate (16) through a conductive pad (22', 40), onto lower substrate (12), to edge connector (20) on the lower substrate, an edge connector (not shown) may alternatively be provided along the external edge of gasket (14'). A potential benefit of forming electrical connections directly from gasket (14') to upper substrate (16) is that the external dimension of lower substrate (12) may be kept to a minimum. Furthermore, there is a reduced likelihood of a corrupted conductive pathway between the substrate layers. In that case, a rather simpler gasket could be employed, such as is illustrated in Fig. 6a, which is a plan view of an EWOD device according to this embodiment and Fig 6b which is a plan view of the gasket of the EWOD device of figure 6a. The upper substrate of the EWOD device corresponds to the upper substrate of fig. 5c, and is provided with a common electrode and one or more pairs of electrodes 36, 38. The gasket is provided with conductive paths 25 and, when the device is assembled, the common electrode and the one or more pairs of electrodes 36, 38 make electrical contact with a respective conductive path in/on the gasket. The gasket illustrated here could be non-conducting for the main part, but for example with a printed circuit on just one surface, without the need for any 'via' structures that create local conductance in the 'z' direction.

The device of Fig. 6a would require two independent edge connectors, or an edge connector having two parts, to provide electrical interface between the device and an instrument; one connector (or part) for making connections to components provided on the upper substrate and another connector (or part) to make electrical connection to any components provided on the lower substrate. This is indicated by the line 20a in figure 6a, which denotes there are two parts to the edge connector 20. One part makes connections to components on the lower substrate only, and the other part makes connections to the upper substrate only, including connections to the conductive tracks 36' and 38'. (In this embodiment the lower substrate may be generally conventional, for example a TFT lower substrate).

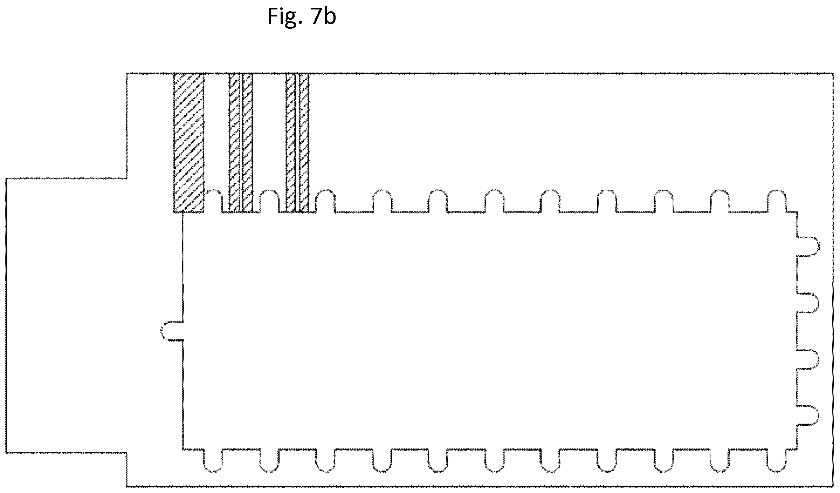

An alternative arrangement is to have a single FPC connector that provides electrical connections to both lower and upper substrates, as illustrated in Figs. 7a and 7b - fig.7a is a plan view of an EWOD device according to this embodiment, and fig. 7b is a plan view of the gasket 14'. (Only the tracks from the upper substrate are depicted, and conductive tracks on the lower substrate are not depicted, except for the edge connector 20.) Here anisotropic gasket 14' extends beyond the boundary of lower substrate (12). Such an anisotropic gasket (14') may consist of an insulating layer, with printed circuits on both sides (the printed circuits on one side providing signals to/from the lower substrate and the printed circuits on the other side providing signals to/from the upper substrate respectively). The thickness of anisotropic gasket (14') determines the height of cavity (26) of the electrowetting device. Alternatively, an external electrical connection may be made directly to the top plate electrodes 36, 38 via the conductive tracks 36', 38', rather than connection being tracked back to the edge connector 20.

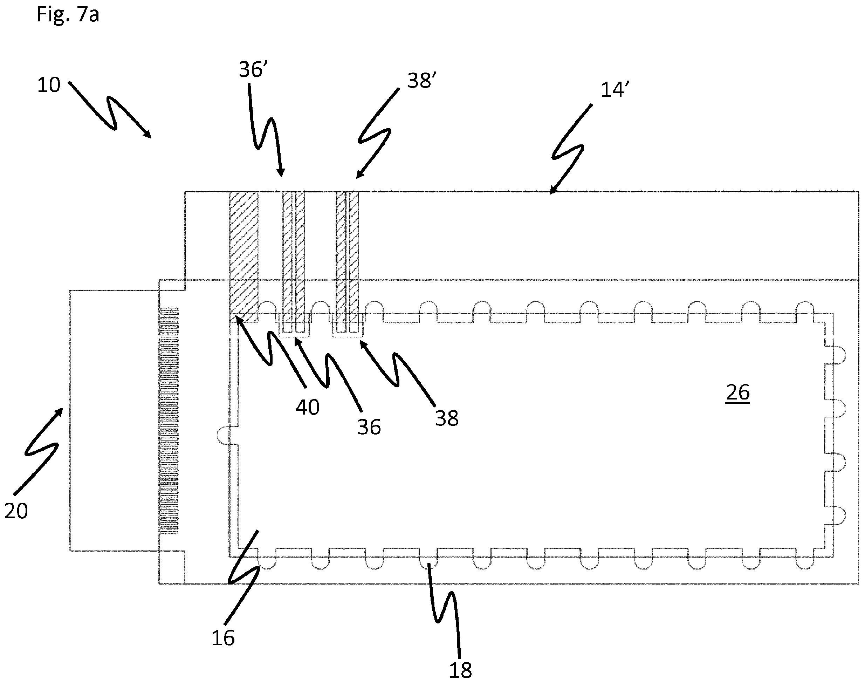

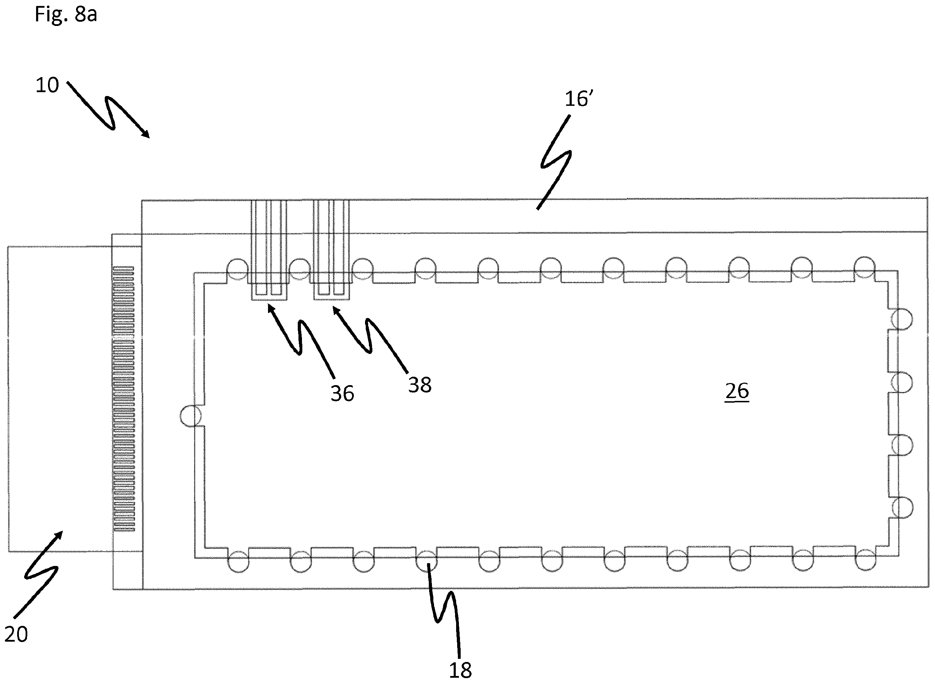

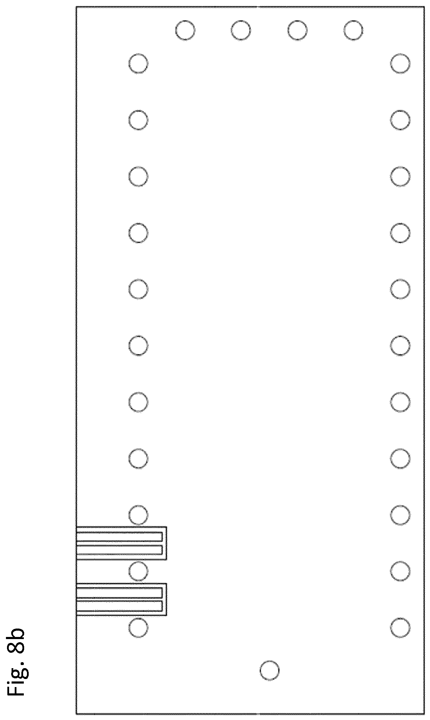

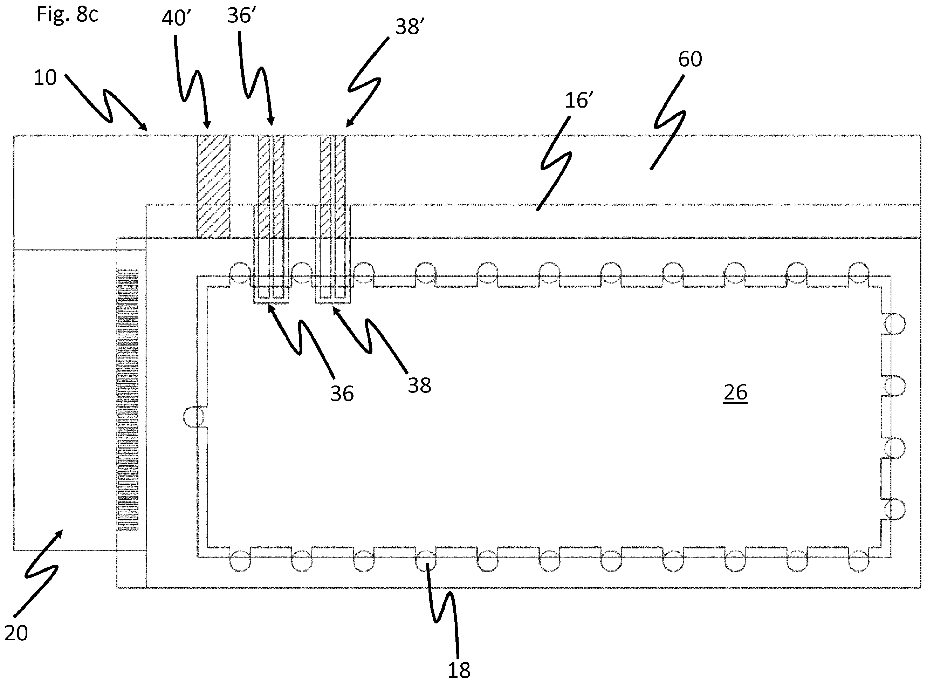

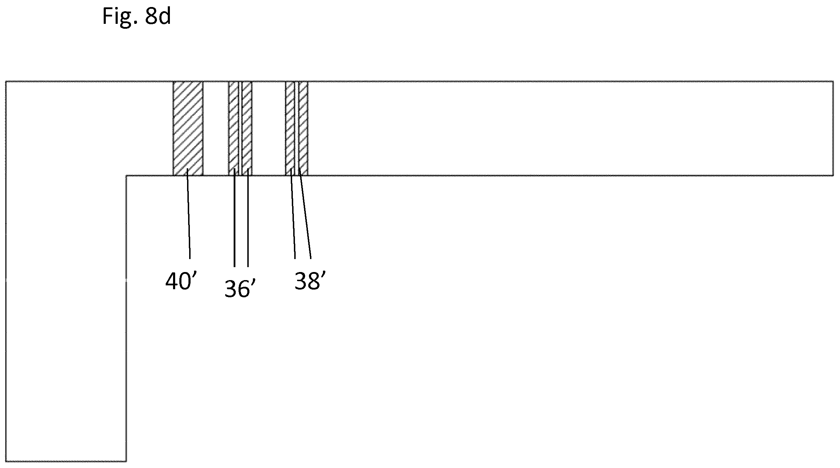

Fig. 8a depicts an EWOD Device according to a further embodiment of the invention, in which upper substrate (16') (shown separately in fig. 8b) comprises an extended long edge profile, which over hangs a long edge of lower substrate (12). Electrodes pairs (36, 38) are etched into a conductive layer (such as an ITO layer) provided on the major surface of upper substrate (16), which faces cavity (26). In the context of Fig. 8a the gasket used to separate upper substrate (16') from lower substrate (12) does not create an electrical bridge between the respective substrates. Rather an FPC or PCB connector may be bonded directly to the conductive tracks on the respective substrates for connection to an instrument. Fig. 8c depicts the EWOD device after provision with a connector, (shown in fig. 8d) in this example an FPC (60), which defines conductive paths (36', 38', 40') that are electrically bonded to the respective elements of upper substrate (16'). That is, the conductive paths 36', 38' on the connector are bonded to electrodes of the electrode pairs 36, 38 defined in the ITO layer on the upper substrate, and the remaining conductive path (40') forms an electrical path to the main part of the ITO layer on upper substrate (16') that acts as the counter or ground electrode to the circuits of the TFT layer on lower substrate (12). As for the embodiment of figure 7a, an external electrical connection may be made directly to the top plate electrodes 36, 38 via the conductive tracks, rather than connection being tracked back to the edge connector 20.

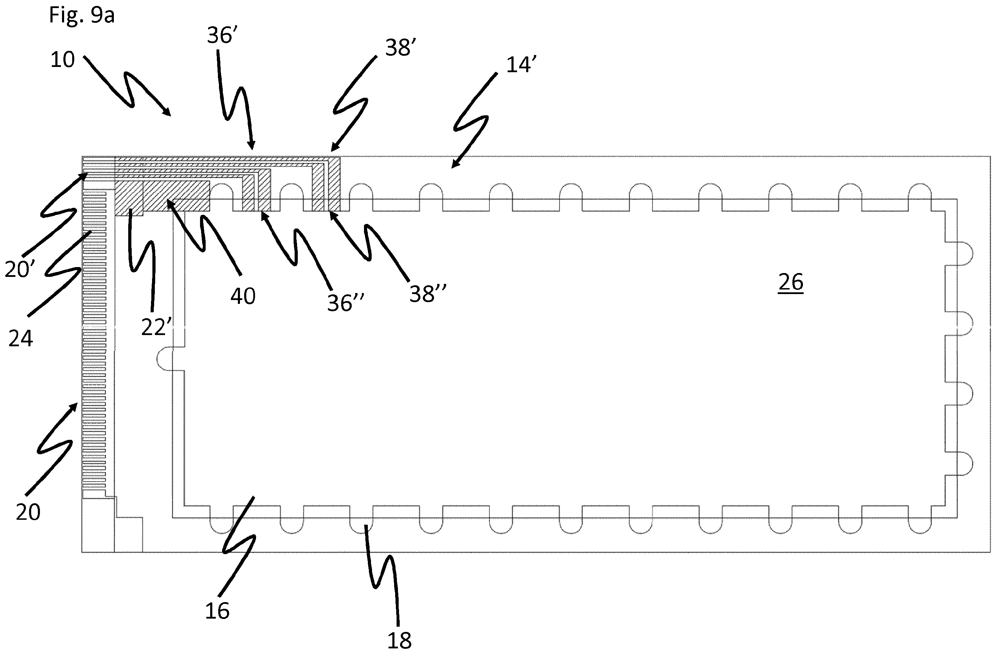

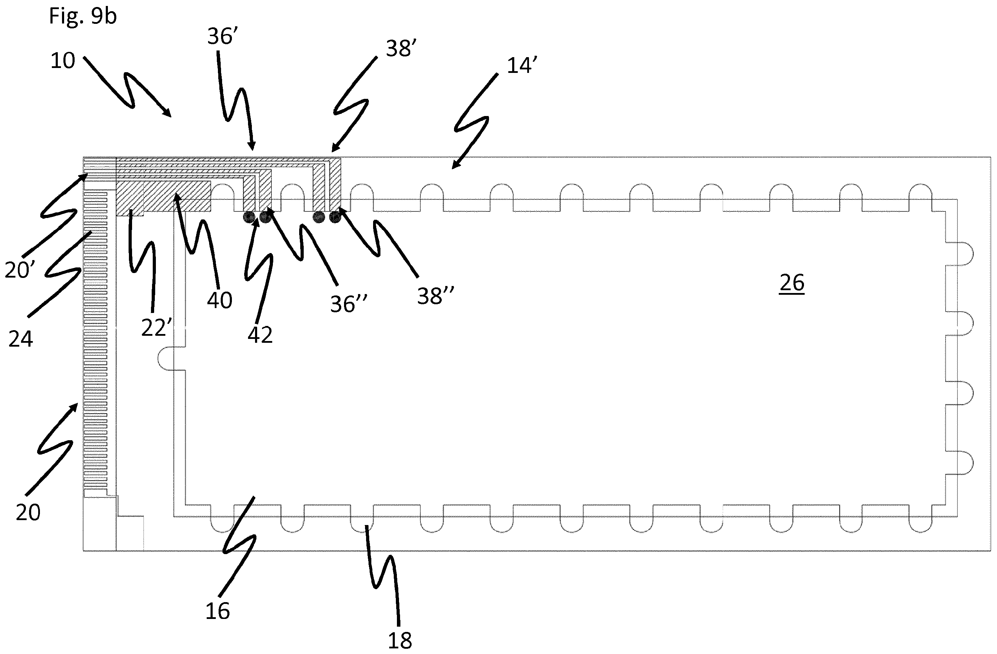

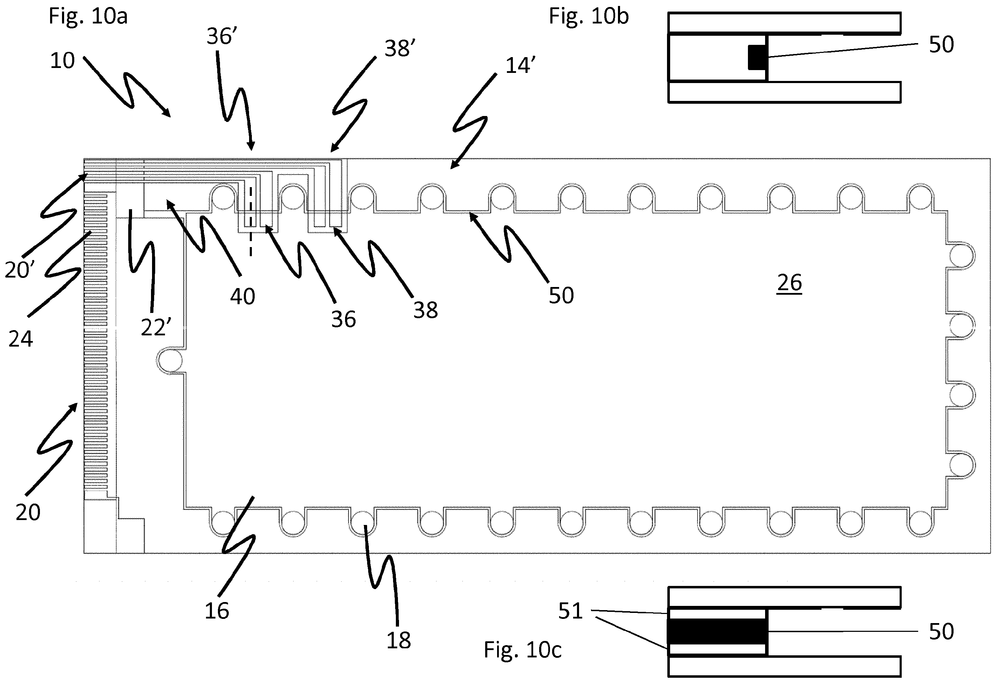

In a further aspect of the invention, as depicted with respect to Figs. 9(a-b), discrete conductive circuits are provided within anisotropic gasket (14') but not on the inner surface of upper substrate (16) that faces cavity (26). In such aspect, a single conductive layer is provided across the entire surface of upper substrate (16) that faces cavity (26), for example to form a common electrode. The gasket 14' is provided with a conductive path/pad 40 that, when the device is assembled, contacts a pad 22 on the lower substrate and also contacts the conductive layer on the inner surface of the upper substrate. The anisotropic gasket (14') also comprises one or more pairs of electrodes (36", 38") the edges of which may be contacted by pair of droplets (42). The gasket of an EWOD according to this embodiment may correspond generally to the gasket of figure 5d when seen in plan view, except that the conductive paths 36', 38' do not, when the device is assembled, contact the conductive layer on the inner surface of the upper substrate but instead may contact fluid droplets 42 in the fluid chamber (for example, the conductive paths 36', 38' may be formed as shown in figure 10c below).

In some aspects, anisotropic gasket (14') may comprise more than one pair of electrodes (36", 38") in a stacked configuration, in which multiple conductive layers are disposed one above another with an insulating layer between. For example, the gasket may be multi-lamellar, which is a common construct used in flexible printed circuits - see https://kenvins.wordpress.com/2014/07/25/next-up-flexible-stackup-type-pcb/ as an example. Respective pairs of electrodes may accordingly be actuated in an x-plane or a z-plane with respect to cavity (26). As illustrated in Figure 9a, the conductive paths track through the gasket to the lower substrate in the manner described for Figures 4 and 5. However, it will be appreciated that they could also track directly to an external connector, for example in the manner described for Figure 6.

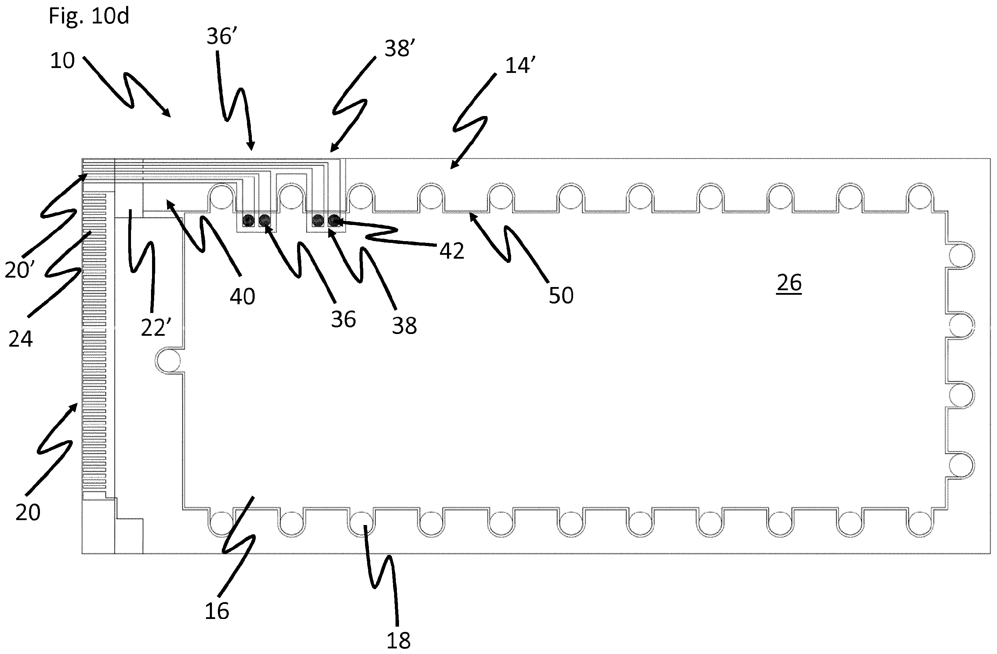

As depicted in Figs. 10(a-d), when an anisotropic gasket (14') is utilised, a conductive edge (50) may be provided around the inner edge of the gasket that defines the gap between lower substrate (12) and upper substrate (16). Conductive edge (50) may be used to achieve voltage setting of a liquid sample that comes in contact therewith, in a similar manner as described with reference to figures 2e and 2f. Extended edge connector (20') may be provided on either side of edge connector (20), to feed electrode pair tracks (36', 38') to the edge of AMEWOD device (10) for connection to an instrument (not shown). Note that in order to ensure that conductive edge (5) does not contact electrodes (36, 38) and form a short circuit between them, it is necessary that the conductive edge does not touch the upper substrate. For similar reasons, it may also be disadvantageous for it to contact the lower substrate. A suitable structure may therefore be a layered gasket, comprising at least 3 layers, in which the outer layers are non-conductive, and is illustrated in Fig. 10b which is a cross-section through the EWOD of fig 10a along the broken line in fig. 10a. (The gasket of an EWOD according to this embodiment may again correspond generally to the gasket of figure 5d when seen in plan view, except that the edge profile features where electrode pairs 36, 38 are present project further towards the interior of the gasket.)

In a further aspect of the invention, the conducting layer within the gasket of the previous embodiment could extend beyond the extents shown in Fig. 10(a-b), so that it covers most if not all of the area surrounding the active area on the lower substrate, as shown in the alternative second cross-section of Fig. 10(c). This structure may have the advantage of reducing the likelihood of electrostatic discharge, either from a user of AMEWOD device (10) or the environment, from damaging the sensitive thin film transistor (TFT) circuits present on the surface of lower substrate (12) that faces cavity (26). The gasket effectively provides a conductive ring around the TFT circuits that connects with a contact (24) on edge connector (20). The conductive edge 50 is connected to a further track (not shown) in the gasket, that makes contact with the lower substrate; thus, any static discharging onto the device may be conducted around the gasket, rather than through the TFT layer.

In a further modification of figs 10a-10d, the gasket may simply provide electrical shielding, to limit the effects on the EWOD substrate of the drive electronics that surround the TFT electronics. The drive electronics can have ill effects on device performance. In this case the gasket may have a cross-section as shown in figure 10b or 10c - that is, there is a conductive layer or conductive edge 50 within the gasket, so that the gasket is not conductive through its entire thickness. In the 'sandwich structure' of fig 10c, for example, the two outer layers 51 may be layers of non-conductive adhesive, and only the inner conductive layer or conductive edge 50 is conductive. The inner conductive layer or conductive edge 50 may be connected to ground, connected to an alternative reference electrode or left floating.

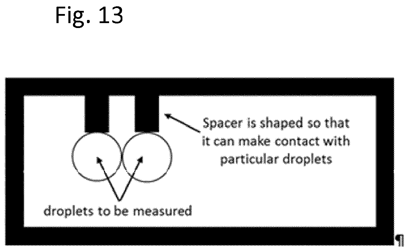

Fig. 13 is a schematic illustration of another application of a device of the invention. In this application the electrodes of an electrode pair are used as sensing electrodes capable of passing electrical signals to and from neighbouring droplets. The method of fig.13 may for example be effected using a device generally as shown in Fig. 4a, but in which the spacing between the electrodes of an electrode pair is such that, when two droplets make contact with the two electrodes of the pair, the two droplets also make contact with one another as shown in Fig. 13 (rather than being separated as shown in Fig. 4f). The electrodes of the electrode pair may be connected to suitable drive/measurement electronics, to allow a property of the droplets, such as their resistivity, to be monitored.

In certain aspects, where an anisotropic gasket (14') is utilised, such gasket may be realised using an anisotropic conductive film (ACF) (such as for example 3M ACF 7303 from Minnesota Mining and Manufacturing Company, Minnesota USA, or Hitachi AC-7106U-25 from Hitachi). Such anisotropic material comprises conductive particles dispersed in a non-conducting carrier. When such an ACF film is compressed, it becomes conductive through the layer thickness, but remains insulating along its length and width. Due to the limited conductive pathways that might be achieved when using ACF material, a multi-layer flexible circuit may be used to yield an anisotropic gasket (14') that permits definition of more complex circuits within the AMEWOD device (10). (see e.g. https://www.flexiblecircuit.com/products/multi-layer-flex/). Such circuits are generally made from layers of insulator (such as polyimides, such as Kapton^{™}) and conductor, such as copper and gold.

## Claims

1. A microfluidic device (10) comprising:
a first substrate (12) and a second substrate (16);
a gasket (14') spacing the first substrate (12) from the second substrate (16) in a thickness direction to define a fluid chamber (26) between the first substrate and the second substrate, an inner edge face of the gasket defining a lateral boundary of the fluid chamber;
a plurality of independently addressable array elements provided on a surface of the first substrate facing the fluid chamber;
a plurality of circuit elements (36,38), the circuit elements being disposed on a surface of the second substrate (16) facing the fluid chamber (26); and
at least one port (18,28) for introducing a fluid sample into the fluid chamber;
**characterised in that** the gasket (14') is configured to provide multiple independent electrically conductive paths (36', 38') extending at least in a plane of the gasket, each conductive path extending between a respective one of the circuit elements and a respective associated terminal along a direction transverse to the thickness direction; and
**in that** the terminals are provided on the gasket (14') at a location spaced from the inner edge face of the gasket.

2. A device as claimed in claim 1, wherein the gasket comprises a projecting portion that projects beyond the first substrate and the second substrate, and wherein the conductive paths extend to the projecting portion of the gasket.

3. A device as claimed in claim 1 or 2 wherein an electrically conductive layer is provided on the surface of the second substrate facing the fluid chamber layer, the circuit elements being defined in the electrically conductive layer.

4. A device as claimed in claim 1, 2 or 3, wherein the gasket further provides a conductive path between a conductive member disposed in part of the inner edge face of the gasket and an associated terminal.

5. A device as claimed in claim 1, 2 or 3, wherein the gasket comprises a material having an anisotropic electrical conductivity.

6. A device as claimed in any preceding claim wherein the inner edge face of the gasket is shaped to define the at least one port.

7. A method comprising:
introducing a fluid sample into the fluid chamber of a device as defined in any one of claims 1 to 6;
controlling the array elements provided on the first substrate of the device so as to move the fluid sample to be adjacent to the circuit element, or to a selected one of the circuit elements, disposed on the second substrate; and
applying a voltage to the terminal associated with the circuit element or with the selected circuit element.

8. A method as claimed in claim 7 and comprising applying the voltage to thereby charge the fluid sample.

9. A method as claimed in claim 8 and comprising performing one or more further fluidic operations on the charged fluid sample,

10. A method as claimed in claim 9 wherein performing the one or more further fluidic operations on the charged fluid sample comprises separating at least one fluid droplet from the fluid sample.

11. A method as claimed in claim 7 and comprising applying the voltage to thereby pass a measurement signal through the fluid sample.

## Patentansprüche

1. Mikrofluidische Vorrichtung (10), umfassend:
ein erstes Substrat (12) und ein zweites Substrat (16);
eine Dichtung (14'), die das erste Substrat (12) von dem zweiten Substrat (16) in einer Dickenrichtung beabstandet, um eine Fluidkammer (26) zwischen dem ersten Substrat und dem zweiten Substrat zu definieren, wobei eine innere Randfläche der Dichtung eine seitliche Begrenzung der Fluidkammer definiert;
eine Vielzahl von unabhängig adressierbaren Arrayelementen, die auf einer der Fluidkammer zugewandten Oberfläche des ersten Substrats bereitgestellt sind;
eine Vielzahl von Schaltungselementen (36, 38), wobei die Schaltungselemente auf einer Oberfläche des zweiten Substrats (16) angeordnet sind, die der Fluidkammer (26) zugewandt ist; und
mindestens einen Anschluss (18, 28) zur Einführung einer Fluidprobe in die Fluidkammer;
**dadurch gekennzeichnet, dass** die Dichtung (14') konfiguriert ist, um mehrere unabhängige elektrisch leitfähige Pfade (36', 38') bereitzustellen, die sich mindestens in einer Ebene der Dichtung erstrecken, wobei sich jeder leitfähige Pfad zwischen einem jeweiligen der Schaltungselemente und einem jeweiligen zugehörigen Anschluss entlang einer Richtung transversal zur Dickenrichtung erstreckt; und
die Anschlüsse sind auf der Dichtung (14') an einer Stelle bereitgestellt, die von der inneren Randfläche der Dichtung beabstandet ist.

2. Vorrichtung nach Anspruch 1, wobei die Dichtung einen vorstehenden Abschnitt umfasst, der über das erste Substrat und das zweite Substrat hinausragt, und wobei sich die leitfähigen Pfade bis zu dem vorstehenden Abschnitt der Dichtung erstrecken.

3. Vorrichtung nach Anspruch 1 oder 2, wobei auf der Oberfläche des zweiten Substrats, die der Fluidkammerschicht zugewandt ist, eine elektrisch leitfähige Schicht bereitgestellt wird, wobei die Schaltungselemente in der elektrisch leitfähigen Schicht definiert sind.

4. Vorrichtung nach Anspruch 1, 2 oder 3, wobei die Dichtung ferner einen leitfähigen Pfad zwischen einem leitfähigen Element, das in einem Teil der inneren Randfläche der Dichtung angeordnet ist, und einem zugehörigen Anschluss bereitstellt.

5. Vorrichtung nach Anspruch 1, 2 oder 3, wobei die Dichtung ein Material aufweist, das eine anisotrope elektrische Leitfähigkeit besitzt.

6. Vorrichtung nach einem der vorstehenden Ansprüche, wobei die innere Randfläche der Dichtung so geformt ist, dass sie die mindestens einen Anschluss definiert.

7. Verfahren, umfassend:
Einführen einer Fluidprobe in die Fluidkammer einer Vorrichtung nach einem der Ansprüche 1 bis 6;
Steuern der auf dem ersten Substrat der Vorrichtung bereitgestellten Arrayelemente, um die Fluidprobe in die Nähe des auf dem zweiten Substrat angeordneten Schaltungselements oder eines ausgewählten Schaltungselements zu bewegen; und
Anlegen einer Spannung an den Anschluss, der mit dem Schaltungselement oder dem ausgewählten Schaltungselement verbunden ist.

8. Verfahren nach Anspruch 7, umfassend das Anlegen der Spannung, um dadurch die Fluidprobe zu laden.

9. Verfahren nach Anspruch 8, umfassend die Durchführung einer oder mehrerer weiterer fluidischer Operationen an der geladenen Fluidprobe.

10. Verfahren nach Anspruch 9, wobei die Durchführung der einen oder mehreren weiteren fluidischen Operationen an der geladenen Fluidprobe die Abtrennung mindestens eines Fluidtropfens von der Fluidprobe umfasst.

11. Verfahren nach Anspruch 7, umfassend das Anlegen der Spannung, um dadurch ein Messsignal durch die Fluidprobe zu leiten.

## Revendications

1. Dispositif microfluidique (10) comprenant :
un premier substrat (12) et un second substrat (16) ;
un joint (14') espaçant le premier substrat (12) du second substrat (16) dans une direction d'épaisseur pour définir une chambre de fluide (26) entre le premier substrat et le second substrat, une face de bord intérieure du joint définissant une limite latérale de la chambre de fluide ;
une pluralité d'éléments de réseau adressables indépendamment prévus sur une surface du premier substrat faisant face à la chambre de fluide ;
une pluralité d'éléments de circuit (36, 38), les éléments de circuit étant disposés sur une surface du second substrat (16) faisant face à la chambre de fluide (26) ; et
au moins un orifice (18, 28) permettant d'introduire un échantillon de fluide dans la chambre de fluide ;
**caractérisé en ce que** le joint (14') est configuré pour fournir de multiples chemins conducteurs électriques indépendants (36', 38') s'étendant au moins dans un plan du joint, chaque chemin conducteur s'étendant entre un élément respectif des éléments de circuit et une borne associée respective le long d'une direction transversale à la direction d'épaisseur ; et
**en ce que** les bornes sont prévues sur le joint (14') au niveau d'un emplacement espacé de la face de bord intérieure du joint.

2. Dispositif selon la revendication 1, dans lequel le joint comprend une partie saillante qui fait saillie au-delà du premier substrat et du second substrat, et dans lequel les chemins conducteurs s'étendent jusqu'à la partie saillante du joint.

3. Dispositif selon la revendication 1 ou 2, dans lequel une couche électriquement conductrice est prévue sur la surface du second substrat faisant face à la couche de chambre de fluide, les éléments de circuit étant définis dans la couche électriquement conductrice.

4. Dispositif selon la revendication 1, 2 ou 3, dans lequel le joint fournit en outre un chemin conducteur entre un élément conducteur disposé dans une partie de la face de bord intérieure du joint et une borne associée.

5. Dispositif selon la revendication 1, 2 ou 3, dans lequel le joint comprend un matériau présentant une conductivité électrique anisotrope.

6. Dispositif selon une quelconque revendication précédente, dans lequel la face de bord intérieure du joint est formée pour définir au moins un orifice.

7. Procédé comprenant :
l'introduction d'un échantillon de fluide dans la chambre de fluide d'un dispositif tel que défini dans l'une quelconque des revendications 1 à 6 ;
la commande des éléments de réseau prévus sur le premier substrat du dispositif de manière à déplacer l'échantillon de fluide pour qu'il soit adjacent à l'élément de circuit, ou à un élément sélectionné parmi les éléments de circuit, disposé sur le second substrat ; et
l'application d'une tension à la borne associée à l'élément de circuit ou à l'élément de circuit sélectionné.

8. Procédé selon la revendication 7 et comprenant l'application de la tension pour charger ainsi l'échantillon de fluide.

9. Procédé selon la revendication 8 et comprenant la réalisation d'une ou de plusieurs opérations fluidiques supplémentaires sur l'échantillon de fluide chargé.

10. Procédé selon la revendication 9, dans lequel la réalisation d'une ou de plusieurs opérations fluidiques supplémentaires sur l'échantillon de fluide chargé comprend la séparation d'au moins une gouttelette de fluide de l'échantillon de fluide.

11. Procédé selon la revendication 7 et comprenant l'application de la tension pour ainsi faire passer un signal de mesure à travers l'échantillon de fluide.
